# EUROPÄISCHE PATENTANMELDUNG

(11) **EP 4 530 370 A1**
(43) Veröffentlichungstag der Anmeldung: **02.04.2025**
(21) Anmeldenummer: 24196242.2
(22) Anmeldetag: 23.08.2024
(51) Int. Cl.: C23C 16/04, C23C 16/40, C23C 16/448, C23C 16/455, C23C 16/511, C23C 16/52, C23C 16/54

(54) **VERFAHREN UND VORRICHTUNG ZUR VERSORGUNG EINER ANLAGE ZUR BESCHICHTUNG VON WERKSTÜCKEN MIT FÜR DEN BESCHICHTUNGSPROZESS BENÖTIGTEN PROZESSGASEN**

(30) Priorität: 30.08.2023 DE 102023123287
(71) Anmelder: KHS GmbH, 44143 Dortmund (DE)
(72) Erfinder: Herbort, Michael, 44143 Dortmund (DE); Vogelsang, Andreas, 44143 Dortmund (DE); Kytzia, Sebastian, 44143 Dortmund (DE)
(74) Vertreter: Eisenführ Speiser

(57) **Zusammenfassung**

Die Erfindung betrifft ein Verfahren zur Versorgung einer Anlage (10) zur Beschichtung von Werkstücken (5) mit für den Beschichtungsprozess benötigten Prozessgasen, wobei wenigstens zwei Grundgase in wenigstens zwei Grundgasleitungen (102, 104; 124, 125) geführt werden bis zu einem Mischpunkt (171, 172, 173) und dort zu einem Gasgemisch zusammengeführt werden, wobei wenigstens eines der Grundgase erzeugt wird durch Überführen eines flüssigen Ausgangsfluides in den gasförmigen Zustand, nämlich durch Erhitzen auf eine Temperatur oberhalb von dessen Siedetemperatur. Das Ausgangsfluidwird hierzu in einem Verdampfer (112a, 112b, 114a, 114b) bereitgestellt, in dem dann das Erhitzen auf eine Temperatur oberhalb der Siedetemperatur erfolgt und in dem über eine zugeordnete Pumpeinrichtung (250) Unterdruckbedingungen eingestellt werden, wobei der Verdampfer (112a, 112b, 114a, 114b) betrieben wird, einen Betriebsdruck und eine Betriebstemperatur zu erreichen und beizubehalten und bei Erreichen dieser Betriebswerte aus dem Verdampfer (112a, 112b, 114a, 114b) das entstehende Grundgas in die zugehörige Grundgasleitung (124, 125) abgegeben wird. Der Verdampfer (112a, 112b, 114a, 114b) ist über eine Nachfüllleitung (210, 240) an einen Vorrat (212, 232) für das Ausgangsfluid angeschlossen und wird darüber zeitweise mit dem Ausgangsfluid nachbefüllt. Zusätzlich ist ein zweiter Verdampfer (112b, 114b) vorgesehen, in dem das gleiche Ausgangsfluid bereitgestellt wird, in dem ebenfalls ein Erhitzen auf eine Temperatur oberhalb der Siedetemperatur erfolgt und in dem ebenfalls über eine zugeordnete Pumpeinrichtung (250) Unterdruckbedingungen einstellt, wobei der zweite Verdampfer (112b, 114b) auf dem gleichen Betriebsdruck und die gleiche Betriebstemperatur wie der erste Verdampfer (112a, 114a) betrieben wird. Der zweite Verdampfer (112b, 114b) gibt das Grundgas in die zugehörige Grundgasleitung (124, 125) ab, wenn der erste Verdampfer (112a, 112b) kein Grundgas in die zugehörige Grundgasleitung (124, 125) abgibt und umgekehrt, sodass also zur Abgabe des Grundgases zwischen diesen beiden Verdampfern (112a, 112b; 114a, 114b) umgeschaltet werden kann, die ein Verdampferpaar (112, 114) bilden. Bevorzugt ist auch der zweite Verdampfer (112b, 114b) des Verdampferpaares (112, 114) über eine Nachfüllleitung (210, 240) an dem Vorrat (212, 232) für das Ausgangsfluid angeschlossen und wird darüber zeitweise mit dem Ausgangsfluid nachbefüllt, wobei bevorzugt das Nachfüllen des ersten Verdampfers (112a, 114a) erfolgt, wenn der zweite Verdampfer (112b, 114b) das Grundgas in die Grundgasleitung (124, 125) abgibt und umgekehrt.

## Beschreibung

Die Erfindung betrifft ein Verfahren nach dem Oberbegriff von Anspruch 1, insbesondere betrifft die Erfindung ein Verfahren für die Versorgung von solchen Beschichtungsanlagen mit Prozessgasen, in denen Innenwände von Behältern beschichtet werden, insbesondere mittels eines PECVD-Verfahrens (plasma enhanced chemical vapordeposition), insbesondere mittels eines mikrowelleninduzierten PECVD-Verfahrens, insbesondere von Behältern aus PET, z.B. von PET-Flaschen.

Die Erfindung betrifft darüber hinaus eine Vorrichtung zur Versorgung von Beschichtungsanlagen nach dem Oberbegriff von Anspruch 7, insbesondere betrifft die Erfindung Versorgungsvorrichtungen, welche Beschichtungsanlagen mit Prozessgasen versorgen, in denen Innenwände von Behältern beschichtet werden, insbesondere mittels eines PECVD-Verfahrens, insbesondere mittels eines mikrowelleninduzierten PECVD-Verfahrens, insbesondere von Behältern aus PET, z.B. von PET-Flaschen. Ein weiterer Aspekt der Erfindung betrifft Anlagen zur Beschichtung von Werkstücken mit einer solchen Versorgungsvorrichtung.

Bei der chemischen Gasphasenabscheidung (CVD) werden Schichten auf Werkstücken chemisch aus der Gasphase abgeschieden. Es ist bekannt, diesen Beschichtungsvorgang durch gezieltes Erzeugen eines Plasmas zu beschleunigen. Es ist auch bekannt, das Plasma durch die Verwendung von Mikrowellenstrahlung zu erzeugen.

Verfahren und Vorrichtungen zur Versorgung von Beschichtungsanlagen mit benötigten Prozessgasen sind z.B. aus der EP 1 954 851 B1 bekannt. Solche Beschichtungsanlagen und solche Versorgungseinrichtungen für die Prozessgaszuführung zu solchen Beschichtungsanlagen sind auch aus der WO 03/10120 A2 bekannt. Gasversorgungsvorrichtungen sind auch kommerziell erhältlich.

In diesem Stand der Technik ist unter anderem gezeigt, dass benötigte Prozessgase durch das Mischen von Grundgasen bereitgestellt werden. Unter anderem erfolgt z.B. ein Mischen von schon in Gasform vorliegenden Grundgasen mit Grundgasen, die erst durch Verdampfen eines Ausgangsfluides bereitgestellt werden müssen. Die Erfindung geht davon aus, dass mindestens ein Grundgas nicht bereits gasförmig vorliegt, sondern dass dieses Grundgas durch Verdampfen eines Ausgangsfluides innerhalb einer Versorgungsvorrichtung bereitgestellt werden muss. Beispiele für ein solches Ausgangsfluid sind HMDSO (Hexamethyldisiloxan) oder HMDSN (Hexamethyldisilazan) oder andere Monomere. Die genannten Ausgangsfluide, auch als Precursor bezeichnet, werden z.B. verwendet zur Abscheidung quarzähnlicher Schichten von Siliziumdioxid. Für dieses Verdampfen ist erforderlich, dass das Ausgangsfluid erwärmt wird wenigstens bis zum Erreichen der Siedetemperatur und dadurch in den gasförmigen Aggregatzustand übergeht. Dieses Verdampfen erfolgt in sogenannten Verdampfern.

Es ist z.B. bekannt, Leitungen, Ventile oder auch Massenflussregler (MFC), durch die das durch Verdampfen entstandene Gas geleitet wird, ebenfalls auf einer Temperatur oberhalb der Siedetemperatur zu halten, damit das entstandene Gas nicht auf seinem weiteren Weg kondensiert. Auch Bereiche, in denen das durch Verdampfen entstandene Grundgas mit anderen Grundgasen zu einem Prozessgasgemisch zusammengeführt und dadurch gemischt wird, auch als Mischbereiche zu bezeichnen, werden in der Regel auf einer Temperatur oberhalb der Siedetemperatur gehalten. Zu dem genannten Zweck ist bekannt, dass Prozessgasversorgungsvorrichtungen einen von Wänden umgebenen Warmbereich aufweisen, der auf einer Temperatur größer oder gleich der Siedetemperatur für den Precursor gehalten ist. Der Warmbereich ließe sich zutreffend auch als Warmkammer bezeichnen. Die genannten Leitungen, Ventile oder auch MFC sowie auch die Mischbereiche, in denen die Grundgase zu den Prozessgasgemischen zusammengeführt werden, sind in diesem Warmbereich angeordnet.

Zusätzlich ist möglich, dass ein Grundgas bereits in Gasform vorliegt und z.B. der Versorgungsvorrichtung in dieser Gasform von außen zugeführt wird. Dieses bereits gasförmig vorliegende Grundgas könnte aber auch in einem Gasvorrat innerhalb der Vorrichtung bereitgehalten sein. Üblicher ist das Zuführen des gasförmigen Grundgases zu der Versorgungsvorrichtung, z.B. durch Anschließen der Versorgungsvorrichtung an Gasversorgungsleitungen. Ein solches schon in Gasform vorliegendes Grundgas kann z.B. Argon sein; Sauerstoff, Stickstoff oder andere aus Beschichtungsverfahren bekannte Gase, die z.B. als Trägergase verwendet werden, sind ebenfalls zu nennen.

Gerade im Bereich der Innenbeschichtung von Behältern, z.B. von Flaschen aus einem thermoplastischen Kunststoff, z.B. aus PET, erfolgt dieses Beschichten bevorzugt auf Rundläufern, d. h. die Plasmastationen, in denen die Behälter mit einer Innenbeschichtung versehen werden, sind auf einem umlaufenden Beschichtungsrad angeordnet. Dies ermöglicht hohe Produktionsraten. Für das Erreichen hoher Produktionsraten und für deren weitere Erhöhung ist erforderlich, dass das Prozessgas in ausreichender Menge bereitgestellt werden kann. Ein Erhöhen der Ausstoßleistung setzt voraus, dass die pro Zeiteinheit von der Versorgungsvorrichtung zugeführte Menge an Prozessgasen gesteigert wird.

Sehr hohe Produktionsraten lassen sich erzielen, wenn der Beschichtungsvorgang mit einem PECVD-Verfahren ausgeführt wird. Insofern wird nachfolgend primär abgestellt auf solche PECVD-Verfahren, insbesondere auf mikrowelleninduzierte PECVD-Verfahren und hier insbesondere auf solche zur Innenbeschichtung von Behältern, z.B. von Flaschen aus thermoplastischem Kunststoff, z.B. aus PET. Dies erfolgt lediglich beispielhaft, aber das nachfolgend geschilderte Problem ergibt sich für dieses gewählte Beispiel besonders dringend.

Für die Innenbeschichtung von PET-Flaschen können z.B. HMDSO und/oder HMDSN als Ausgangsfluide verwendet werden. Beide liegen üblicherweise in flüssiger Form vor und müssen zur Bereitstellung als Grundgas verdampft werden. Typischerweise findet das Verdampfen bei etwa 45 °C statt. Die verdampften Monomere werden dann in Leitungen geführt und es erfolgt z.B. eine Dosierung durch in den Leitungen vorgesehene MFC. Damit die verdampften Monomere nicht an den Leitungen oder im MFC kondensieren, werden auch diese Leitungen und das MFC auf eine Temperatur oberhalb von 45 °C gehalten, d. h. der Warmbereich weist wenigstens eine Temperatur von 45 °C auf. Bevorzugt wird diese Temperatur etwa 5°C höher gewählt, als die Siedetemperatur des flüssigen Precursors HMDSO und/oder HMDSN.

Es sind Versorgungsvorrichtungen bekannt, auch Gaserzeuger genannt, in denen zwei flüssige Ausgangsfluide durch Verdampfen in Grundgase umgewandelt und diese dann mit anderen Grundgasen vermischt werden. Pro Ausgangsfluid gibt es zwei Aufbewahrungsfässer im Gaserzeuger. Die Fässer weisen Heizmittel auf, sodass die Fluide zum Zwecke ihrer Verdampfung erhitzt werden können. Die beheizten Fässer stellen prinzipiell Verdampferdar. Die Fässersind auch an Pumpeinrichtungen anschließbar, um in den Fässern Unterdruckbedingungen einzustellen. Bei den Ausgangsfluiden handelt es sich z.B. um die Monomere HMDSO und HMDSN, je Monomer sind also zwei Fässer vorgesehen. Zunächst wird jeweils eines der Fässer zur Gaserzeugung herangezogen. Sobald das Fass weitgehend leer ist, wird die Produktion unterbrochen, händisch auf das zweite Fass umgeschaltet, das bereits erwärmt ist und in dem ein gewünschter Unterdruck herrscht und das für die weitere Produktion verwendet wird, und das erste Fass ausgetauscht gegen ein neues Fass. Danach wird die Produktion wiederaufgenommen und währenddessen das neue Fass erwärmt und mit einer Pumpeinrichtung verbunden, sodass es bei Bedarf wieder angeschlossen werden kann. Diese Vorgehensweise führt zu störenden Unterbrechungen beim Wechselvorgang.

Es ist auch bekannt, die beiden Ausgangsfluide jeweils nur in einem Fass bereitzustellen und bei Leerlaufen eines der Fässer dieses Fass auszutauschen. Pro Monomer ist also nur ein Fass vorhanden. Diese Vorgehensweise erzwingt längere Produktionsunterbrechungen, da einerseits das Fass auszutauschen ist und andererseits das neu eingesetzte Fass zunächst auf Betriebstemperatur und Betriebsdruck zu bringen ist und ggf. zunächst Verunreinigungen abzupumpen sind, bevor Prozessgas in der erforderlichen Qualität von dem neuen Fass bereitgestellt werden kann.

Bei der zuvor genannten Lösung mit zwei Fässern, also pro Monomer ein Fass, ist auch bekannt, eine automatische Nachfüllung der Fässer vorzusehen, also z.B. im laufenden Betrieb immer kleine Mengen nachzufüllen, wobei dies z.B. in Intervallen erfolgt und das Nachfüllvolumen etwa dem verbrauchten Volumen zwischen zwei Nachfüllvorgängen entspricht. Eine solche Lösung vermeidet zwar längere Produktionsunterbrechungen, das intervallhafte Nachfüllen führt aber zu Variationen im bereitgestellten Prozessgas und beeinträchtigt somit die Prozessstabilität des Beschichtungsvorgangs. Eine Ursache dafür ist, dass beim Nachfüllen eine Abkühlung des Ausgangsfluides eintritt und also die durch Verdampfen entstehende Gasmenge geringer wird. Zudem werden während des Nachfüllens mitunter Fremdgase oder Verunreinigungen eingeschleppt.

Wie eingangs ausgeführt besteht ein Bedarf, Beschichtungsanlagen mit immer größerer Ausstoßleistung bereitzustellen. Daher sind Unterbrechungen jeglicher Art störend, z.B. um Ausgangsfluide nachzufüllen oder damit gefüllte Behälter auszutauschen, wie im Falle von HMDSO oder HMDSN zuvor geschildert. Unterbrechungen bei der Gasversorgung z.B. durch Betriebsstörungen im Bereich des Gaserzeugers und daraus resultierende Stillstandsphasen der Beschichtungsmaschine sind ebenfalls nach Möglichkeit zu verhindern.

Bislang gibt es keine zufriedenstellende Lösung, um diesem dargestellten Problem zu begegnen und dennoch die Produktionsrate von Beschichtungsanlagen künftig weiter steigern zu können.

Der Erfindung liegt daher die Aufgabe zugrunde, eine verbesserte Lösung bereitzustellen, welche die genannten Probleme adressiert. Es ist insbesondere die Aufgabe der vorliegenden Erfindung, ein Verfahren der einleitend genannten Art derart weiterzubilden, dass für hohe Produktionsraten von Beschichtungsanlagen möglichst unterbrechungsfrei eine ausreichende Prozessgasmenge und in möglichst konstant guter Qualität bereitgestellt werden kann.

Gemäß einem ersten Aspekt der Erfindung wird die Aufgabe erfindungsgemäß gelöst durch ein Verfahren mit den kennzeichnenden Merkmalen von Verfahrensanspruch 1.

Das erfindungsgemäße Verfahren zeichnet sich dadurch aus, dass wenigstens zwei Grundgase in wenigstens zwei Grundgasleitungen geführt werden bis zu einem Mischpunkt und dort zu einem Gasgemisch zusammengeführt werden. Wenigstens eines der Grundgase liegt originär nicht gasförmig vor, sondern wird erzeugt durch Überführen eines flüssigen Ausgangsfluides in den gasförmigen Zustand, nämlich durch Erhitzen auf eine Temperatur oberhalb von dessen Siedetemperatur. Dazu wird das Ausgangsfluid in einem Verdampfer bereitgestellt. Der Verdampfer weist z.B. ein geeignetes Behältnis oder eine geeignete Kammer für das Ausgangsfluid auf. Im Verdampfer wird das Ausgangsfluid auf eine Temperatur oberhalb seiner Siedetemperatur erhitzt und dadurch in den gasförmigen Zustand überführt. Der Verdampfer weist hierzu eine Heizeinrichtung auf. In dem Verdampfer werden zudem über eine zugeordnete Pumpeinrichtung Unterdruckbedingungen eingestellt. Der Verdampfer wird zur Bereitstellung des Grundgases betrieben, einen Betriebsdruck und eine Betriebstemperatur zu erreichen und beizubehalten und bei Erreichen dieser Betriebswerte aus dem Verdampfer das entstehende Grundgas in die zugehörige Grundgasleitung abzugeben. Hierzu weist der Verdampfer z.B. über einen geeigneten Temperatursensor und einen Drucksensor auf, die in die Steuerung des Verdampfers eingebunden sind. Es wird hier und nachfolgend nicht zwischen Steuerung und Regelung unterschieden, sondern unisono von einem Steuern und einer Steuereinrichtung gesprochen, ohne dass dadurch eine Regelung oder Mischformen aus Steuerung und Regelung ausgeschlossen sind. Es können auch mehr als ein Temperatursensor und/oder mehr als ein Drucksensor eingebunden sein. Der Verdampfer ist über eine Nachfüllleitung an einen Vorrat für das Ausgangsfluid angeschlossen und wird darüber zeitweise mit dem Ausgangsfluid nachbefüllt. Es soll also nicht kontinuierlich und unterbrechungsfrei ein Nachfüllen erfolgen, sondern das Nachbefüllen erfolgt nur zu bestimmten Zeiten, z.B. ausgelöst durch bestimmte Ereignisse oder Zustände. Zusätzlich zu diesem bisher beschriebenen ersten Verdampfer wird ein zweiter Verdampfer vorgesehen. Auch in diesem zweiten Verdampfer wird das gleiche Ausgangsfluid bereitgestellt. Auch im zweiten Verdampfer erfolgt ein Erhitzen auf eine Temperatur oberhalb der Siedetemperatur und auch im zweiten Verdampfer werden über eine zugeordnete Pumpeinrichtung Unterdruckbedingungen eingestellt. Dabei ist bevorzugt, dass der erste und der zweite Verdampfer an unterschiedlichen Pumpeinrichtungen angeschlossen werden, damit die Unterdruckbedingungen in beiden Verdampfern unabhängig voneinander sind und unabhängig voneinander eingestellt werden, also z.B. das Abpumpen des zweiten Verdampfers die Unterdruckbedingungen im ersten Verdampfer nicht beeinflusst. Der zweite Verdampfer wird auf dem gleichen Betriebsdruck und die gleiche Betriebstemperatur wie der erste Verdampfer betrieben. Er weist dazu ebenfalls einen geeigneten Temperatursensor und Drucksensor auf, die in die Steuerung des zweiten Verdampfers eingebunden sind. Das für den ersten Verdampfer Erklärte gilt auch für den zweiten Verdampfer. Der zweite Verdampfer gibt das Grundgas in die zugehörige Grundgasleitung ab, wenn der erste Verdampfer kein Grundgas in die zugehörige Grundgasleitung abgibt und umgekehrt, sodass also zur Abgabe des Grundgases zwischen diesen beiden Verdampfern umgeschaltet werden kann. Erster und zweiter Verdampfer bilden ein Verdampferpaar. Der Vorgang des Umschaltens kann gleichwohl einen kurzen Zeitraum umfassen, in dem sowohl der erste Verdampfer als auch der zweite Verdampfer an die Grundgasleitung angeschlossen sind. Es muss also nicht zwingend zunächst der erste Verdampfer von der Grundgasleitung getrennt und erst danach der zweite Verdampfer mit der Grundgasleitung verbunden werden. Denkbar ist auch, dass zeitgleich das Trennen einerseits und das Verbinden andererseits erfolgt oder kurzzeitig zunächst der zweite Verdampfer verbunden und danach der erste Verdampfer getrennt wird. Dies gilt im umgekehrten Fall ebenso. Das Umschalten erfolgt aber im Sekundenbereich, in der Regel sogar unterhalb einer Sekunde, sodass beide Verdampfer für nicht einmal eine Sekunde gemeinsam angeschlossen wären.

Es ist denkbar, dass der zweite Verdampfer als reine Reserve und in gewisser Weise als Redundanz für den ersten Verdampfer vorgesehen wird. Der zweite Verdampfer würde also nur bei Auftreten eines Betriebsfehlers im ersten Verdampfer aktiv und an die Grundgasleitung angeschlossen werden, oder wenn für den ersten Verdampfer ein Nachfüllen erforderlich ist. Für diese reine Funktion als Reserve müsste der zweite Verdampfer nicht an eine Nachfüllleitung angeschlossen sein, sondern er könnte im Bedarfsfall auch ausgetauscht werden zu einem Zeitpunkt, zu dem der erste Verdampfer das Grundgas zur Verfügung stellt. Allerdings birgt dies die Gefahr, dass in einer solchen Austausch- und Bereitstellungsphase der zweite Verdampfer nicht als Reserve zur Verfügung steht und es also doch zu einer Unterbrechung kommen kann. Insofern wird bevorzugt vorgeschlagen, dass auch der zweite Verdampfer des Verdampferpaares über eine Nachfüllleitung an dem Vorrat für das Ausgangsfluid angeschlossen ist und darüber zeitweise mit dem Ausgangsfluid nachbefüllt wird. Dabei erfolgt das Nachfüllen des ersten Verdampfers bevorzugt, wenn der zweite Verdampfer das Grundgas in die Grundgasleitung abgibt und umgekehrt. Weiter bevorzugt ist, dass das Nachfüllen des einen Verdampfer des Verdampferpaares begonnen wird, sobald auf den anderen Verdampfer umgeschaltet wurde und also der andere Verdampfer das Grundgas in die Grundgasleitung abgibt. Eine Steuerung könnte ein entsprechendes Nachfüllsignal generieren und entsprechend ein zugeordnetes Ventil in der zugeordneten Nachfüllleitung öffnen. Es ist weiter bevorzugt, dass auch bereits während des Nachfüllvorganges das Aufheizen des Ausgangsfluides durchgeführt wird und die Unterdruckbedingungen eingestellt werden, damit möglichst schnell die Betriebswerte erreicht werden und dadurch Betriebsbereitschaft besteht. Es ist weiterhin bevorzugt, dass im Falle des Auftretens einer Betriebsstörung in dem Verdampfer, der zum Zeitpunkt der Betriebsstörung das Grundgas in die Grundgasleitung abgibt, ein im anderen Verdampfer stattfindender Nachfüllvorgang abgebrochen wird und der Verdampfer wieder mit der Grundgasleitung verbunden wird. Es kann aber auch vorgesehen sein, dass zunächst möglichst schnell Betriebsbereitschaft hergestellt wird und erst mit Erreichen der Betriebswerte der Verdampfer Grundgase an die Grundgasleitung abgibt. Alle diese bevorzugten Ausführungsvarianten bewirken, dass auch in ungünstigen Konstellationen Unterbrechungen vermieden, mindestens aber möglichst kurz gehalten werden.

Eine weitere Aufgabe der vorliegenden Erfindung ist es insbesondere, eine Vorrichtung der einleitend genannten Art derart fortzubilden, dass für hohe Produktionsraten von Beschichtungsanlagen eine ausreichende Prozessgasmenge unterbrechungsfrei bereitgestellt wird.

Gemäß einem weiteren Aspekt der Erfindung wird diese genannte Aufgabe erfindungsgemäß gelöst durch eine Vorrichtung mit den kennzeichnenden Merkmalen von Vorrichtungsanspruch 7, die spiegelbildlich sind zu den kennzeichnenden Merkmalen von Verfahrensanspruch 1. Die Vorrichtung weist also die Mittel und Einrichtungen auf, um den Verfahrensablauf in Anspruch 1 und in den davon abhängigen Verfahrensunteransprüchen technisch umzusetzen.

Der weitere Aspekt betrifft also eine Vorrichtung zur Gaserzeugung und zur Versorgung einer Anlage zur Beschichtung von Werkstücken mit für den Beschichtungsprozess benötigten Prozessgasen. Die Vorrichtung weist wenigstens zwei Grundgasleitungen zum getrennten Führen von wenigstens zwei Grundgasen in einer Strömungsrichtung und wenigstens ein Mischmittel zum Zusammenführen und Mischen von wenigstens zwei der Grundgase zu einem Gasgemisch auf. Die Vorrichtung hat zur Bereitstellung eines ersten Grundgases wenigstens einen Verdampfer, der zur Aufnahme einer Menge eines flüssigen Ausgangsfluides eingerichtet ist und der ausgebildet ist zur Überführung des flüssigen Ausgangsfluides in den gasförmigen Zustand, wobei der Verdampfer hierzu insbesondere einen Heizer zum Erwärmen des Ausgangsfluides mindestens bis zu dessen Siedetemperatur aufweist und eine Pumpeinrichtung zum Einstellen eines Unterdruckes im Verdampfer, wobei der Verdampfer steuerungstechnisch für das Erreichen und Beibehalten einer Betriebstemperatur und eines Betriebsdruckes eingerichtet ist. Diese steuerungstechnische Einrichtung bedeutet einerseits, dass für das Erfassen einer Temperatur ein geeigneter Sensor vorhanden und an geeigneter Stelle angeordnet ist, und dass auch für das Erfassen eines Druckes ein geeigneter Sensor vorhanden und an geeigneter Stelle angeordnet ist. Zudem sind die genannten Sensoren in eine Steuerung eingebunden bzw. an eine Steuerungseinrichtung angeschlossen, wobei erneut darauf hinzuweisen ist, dass der Begriff der Steuerung auch eine Regelung oder Mischformen zwischen Regelung und Steuerung umfasst. Der Verdampfer soll so betrieben bzw. von der Steuerung angesteuert sein, dass Betriebswerte für die Temperatur und den Druck angestrebt, erreicht und beibehalten werden. Die Vorrichtung soll zur Bereitstellung des gleichen Grundgases einen zweiten Verdampfer aufweisen, der ebenfalls zur Aufnahme einer Menge des flüssigen Ausgangsfluides eingerichtet ist, und der mit dem ersten Verdampfer ein Verdampferpaar bildet. Auch der zweite Verdampfer ist ausgebildet, das in ihm aufgenommene flüssige Ausgangsfluid in den gasförmigen Zustand zu überführen, wobei er hierzu insbesondere einen Heizer zum Erwärmen des Ausgangsfluides mindestens bis zu dessen Siedetemperatur aufweist und eine Pumpeinrichtung zum Einstellen eines Unterdruckes im Verdampfer, wobei der zweite Verdampfer ebenfalls steuerungstechnisch eingerichtet ist für das Erreichen und Beibehalten der Betriebstemperatur und des Betriebsdruckes. Es gelten die obigen Ausführungen zum ersten Verdampfer und zu dessen Betriebsweise analog für den zweiten Verdampfer. Sowohl der erste Verdampfer als auch bevorzugt der zweite Verdampfer sollen jeweils über eine Nachfüllleitung an einen Vorrat für das Ausgangsfluid angeschlossen sein. Schließlich weist die Vorrichtung eine Steuerungseinrichtung auf, die ausgebildet und eingerichtet ist zur Ausführung eines der in den Verfahrensansprüchen angegebenen Verfahrens.

Es versteht sich, dass dazu mehrere schaltbare Ventile vorhanden sein müssen. Die Verdampfer sind über zugeordnete Leitungen an der Grundgasleitung angeschlossen, wobei diese zugehörigen Leitungen ventilbeherrscht sind. Die Ventile sind von der Steuerungseinrichtung aus einer Offen- in eine Geschlossenstellung überführbar und umgekehrt. Auch die Nachfüllleitungen sind ventilbeherrscht ausgeführt und werden also jeweils von einem schaltbaren Ventil beherrscht. Auch diese schaltbaren Ventile sind von der Steuerungseinrichtung in eine Offen- und eine Geschlossenstellung überführbar und umgekehrt. Auf diese Weise ist die Steuereinrichtung in der Lage, bedarfsweise einen der Verdampfer von der Grundgasleitung zu trennen und den anderen Verdampfer mit der Grundgasleitung zu verbinden. Auf diese Weise ist die Steuereinrichtung in der Lage, das Nachfüllen eines der Verdampfer anzusteuern, indem das entsprechende Ventil in der zugeordneten Nachfüllleitung in die Offenstellung gesteuert wird.

Vorteilhafte Ausgestaltungen der Vorrichtung und des Verfahrens sind in den jeweiligen Unteransprüchen angegeben. Die nachfolgend diskutierten bevorzugten Ausführungsformen des Verfahrens finden sich spiegelbildlich auch in der Vorrichtung wieder. Umgekehrt finden sich die nachfolgend diskutierten bevorzugten Ausführungsformen der Vorrichtung spiegelbildlich auch in dem Verfahren wieder. Die jeweils angegebenen Vorteile des Verfahrens bzw. der Vorrichtung sind spiegelbildlich auch Vorteile der Vorrichtung bzw. des Verfahrens. Das erfindungsgemäße Verfahren kann auf den erfindungsgemäßen Vorrichtungen ausgeführt werden.

Alle vorgestellten Vorrichtungen und Verfahren finden insbesondere Verwendung bei der Beschichtung von Innenwänden von Behältern, insbesondere mittels eines PECVD-Verfahrens, insbesondere mittels eines mikrowelleninduzierten PECVD-Verfahrens. Solche Beschichtungen werden insbesondere bei aus einem thermoplastischen Kunststoff, z.B. PET, bestehenden Flaschen eingesetzt, die z.B. aus Vorformlingen hergestellt werden, um durch das Beschichten die Barriereeigenschaften zu verbessern. Diese Barriereeigenschaften betreffen z.B. einerseits das Eindringen von Sauerstoff von außen in den Behälter und in das darin abgefüllte Füllgut, und andererseits z.B. das Austreten von Kohlendioxid, soweit z.B. ein karbonisiertes Füllgut im Behälter abgefüllt wird.

Die Erfindung in den oben beschriebenen mehreren Aspekten besteht anders ausgedrückt darin, dass pro benötigter Ausgangsflüssigkeit, z.B. pro Monomer, ein Verdampferpaar vorgesehen ist, z.B. in Form beheizter und an eine Pumpeinrichtung angeschlossene Monomerfässer. Einer der Verdampfer pro Paar ist in den Beschichtungsprozess aktiv eingebunden, indem er benötigtes Prozessgas zur Verfügung stellt und in eine Grundgasleitung einspeist, sodass das Gas gemischt und zum Beschichtungsort geführt werden kann. Währenddessen ist der andere Verdampfer des Paares nicht aktiv beteiligt. Er stellt eine Art Reserve dar, sobald darin die Betriebswerte erreicht sind. Zu einem Zeitpunkt, zu dem der aktive Verdampfer z.B. eine Betriebsstörung aufweist, kann der bisher inaktive Verdampfer als Notfallreserve einspringen und unterbrechungsfrei das Grundgas zur Verfügung stellen. Dazu ist der inaktive zweite Verdampfer des Paares bezüglich Druck und Temperatur in der gleichen Art betrieben, wie der jeweils aktive Verdampfer, er steht in Bereitschaft. Der zweite mögliche Fall, zu dem der Reserveverdampfer aktiv werden soll, ist der eigentliche Regelfall, nämlich, dass der zunächst aktive Verdampfer des Verdampferpaares nach einer bestimmten Maschinenlaufzeit einen niedrigen Füllstand an Ausgangsflüssigkeit erreicht, sodass z.B. die Maschinensteuerung oder die Gaserzeugersteuerung oder die Verdampfersteuerung erkennt, dass ein Wechsel auf den inaktiven Verdampfer vorzunehmen ist. Zu diesem Zeitpunkt ist der inaktive Verdampfer des Paares in einem betriebsbereiten Zustand und die Steuerung schließt Ventile zum bisher aktiven Verdampfer und öffnet Ventile zum bisher inaktiven Verdampfer, sodass der inaktive Verdampfer zum aktiven Verdampfer wird und umgekehrt.

Der zuvor aktive Verdampfer soll fortan als Reserveverdampfer dienen und wird nunmehr zunächst nachgefüllt durch Öffnen der Nachfüllleitung, die aus einer externen Quelle gespeist wird, z.B. aus einem großen Tank, z.B. einem Monomertank. Der ehedem aktive Verdampfer wird also zunächst neu mit einem Monomer befüllt und sodann, ggf. auch zeitgleich mit dem Nachfüllen, erfolgt ein Aufheizen des Monomers im Verdampfer und das Einstellen des gewünschten Betriebsdruckes, sodass nach Abschluss dieser Bereitstellungsprozedur der ehedem aktive Verdampfer als vollwertiger und einsatzbereiter Reserveverdampfer zur Verfügung steht und als Notfallreserve einspringen und wieder in den Beschichtungsprozess aktiv zugeschaltet werden kann, wenn der derzeit aktive Verdampfer z.B. einen niedrigen Füllstand an Ausgangsflüssigkeit erreicht.

Bei dem geschilderten Umschalten zwischen den beiden Verdampfern eines Paares ist keine Produktionsunterbrechung erforderlich, da dies einerseits in relativ kurzer Zeit vollzogen werden kann, denn eine Steuerung übernimmt das Umschalten und es sind nur schaltbare Ventile zu schließen und andere schaltbare Ventile zu öffnen. Zu bedenken ist zudem, dass in den Gasleitungen vom Gaserzeuger zu den Prozesskammern, in denen die Prozessgase für Beschichtungsvorgänge benötigt werden, noch eine gewisse Menge an Prozessgas zur Verfügung steht, was wie ein Puffer wirkt. Das Umschalten zwischen den beiden Verdampfern eines Paares führt also nicht unmittelbar und sofort zu einer Unterbrechung der Gaszufuhr am Beschichtungsort, sondern ist dort mit einer gewissen Verzögerung bemerkbar. In einer Übergangsphase nach dem Umschalten liegt Mischgas vor in dem Sinne, dass aus dem aktiven Verdampfer bereitgestelltes Prozessgas vermischt wird mit dem Prozessgas aus dem Reserveverdampfer, sobald der Reserveverdampfer aktiv wird.

Sollte festgestellt werden, dass dieses für kurze Zeit vorliegende Mischgas für eine kurze Zeit zu Beschichtungen führt, die außerhalb der akzeptierten Toleranzen liegen, wäre auch möglich, z.B. kurzzeitig das Zuführen von zu beschichtenden Werkstücken zu unterbrochen, um das Umschalten vorzunehmen, oder z.B. eine bestimmte Anzahl an beschichteten Werkstücken auszuschleusen, die im zeitlichen Umfeld nach dem Umschalten hergestellt worden sind.

Soweit mehrere Grundgase durch Verdampfen flüssiger Precursor bereitgestellt werden, ist es vorteilhaft, für alle diese Grundgase wie oben beschrieben vorzugehen. Die Erfindung ist dabei nicht auf zwei Grundgase beschränkt, die aus flüssigen Ausgangsfluiden erzeugt werden, sondern sie ist auch anwendbar, wenn ein drittes flüssiges Ausgangsfluid hinzutritt. Es wäre dann gegebenenfalls ein drittes Verdampferpaar entlang der technischen Lehre vorzusehen, die oben zum ersten und zum zweiten Verdampferpaar angegeben wurde.

Eine bevorzugte Anwendung findet eine erfindungsgemäße Gasversorgungsvorrichtung in einer Anlage zur Beschichtung von Werkstücken, insbesondere zur Beschichtung von Innenwänden von Behältern, insbesondere mittels eines PECVD-Verfahrens, insbesondere mittels eines mikrowelleninduzierten PECVD-Verfahrens, insbesondere für Behälter aus einem thermoplastischen Kunststoff, z.B. aus PET. Die Erfindung ist besonders geeignet für Anlagen rotierender Bauart, die also ein Beschichtungsrad mit mehreren darauf umfangsbeabstandet angeordneten Beschichtungsstationen aufweist, wobei das Rad eine drehgelagerte Radachse aufweist und mit einem Antrieb versehen ist für eine kontinuierliche Drehbewegung um die Radachse.

Zu den Vorteilen, Ausführungsvarianten und Ausführungsdetails der verschiedenen Aspekte der hier beschriebenen Lösungen und ihrer jeweiligen möglichen Fortbildungen wird auch auf die Beschreibung zu den entsprechenden Merkmalen, Details und Vorteilen der jeweils anderen Aspekte und ihrer Fortbildungen verwiesen. Nachfolgend werden Verfahren und Vorrichtung und bevorzugte Ausführungsvarianten dazu gemischt beschrieben.

Sowohl bezüglich des Verfahrens als auch bezüglich der Vorrichtung ist möglich, dass die beiden Verdampfer eines Verdampferpaares unterschiedlich ausgeführt sind. So könnte z.B. der zweite Verdampfer eines Verdampferpaares reduziert werden auf eine Reservefunktion und z.B. für die Aufnahme einer kleineren Menge an flüssigem Ausgangsfluid ausgeführt sein, und z.B. lediglich die halbe Flüssigkeitsmenge aufnehmen können wie der erste Verdampfer. Die Flüssigkeitsmenge könnte z.B. nur so ausreichend bemessen sein, dass der erste Verdampfer zuverlässig nachgefüllt werden kann und wieder Betriebsbereitschaft erreicht, während der zweite Verdampfer Gas in die Gasleitung abführt, um dann aber bei Erreichen der Betriebsbereitschaft sofort wieder auf den ersten Verdampfer umzuschalten. Der zweite Verdampfer wäre also so auszulegen, dass lediglich zuverlässig die Nachfüllphasen überbrückt sind. Mit Vorteil ist allerdings vorgesehen, dass die beiden Verdampfer des Verdampferpaares identische Mengen an der Ausgangsflüssigkeit aufnehmen und insbesondere identisch ausgeführt sind. Auf diese Weise kann der zweite Verdampfer den ersten Verdampfer vollständig ersetzen und umgekehrt. Insbesondere wird auf diese Weise erreicht, dass beide Verdampfer bezüglich der Steuerung in den Betriebswerten identisch ausgeführt sein können, sodass sich auch steuerungstechnische Erleichterungen ergeben. Anders ausgedrückt ist der erste Verdampfer in identischer Bauform doppelt vorgesehen.

Wie oben ausgeführt ist vorgesehen, dass der erste Verdampfer und bevorzugt auch der zweite Verdampfer für ein Nachbefüllen an einer jeweiligen ventilbeherrschten Nachfüllleitung angeschlossen sind. Es ist dabei mit Vorteil vorgesehen, dass jeder der Verdampfer nach einem Nachbefüllen erst dann mit der dazugehörigen Grundgasleitung verbunden werden kann, wenn wieder die Betriebswerte erreicht sind. Ein Verbinden mit der zugehörigen Grundgasleitung vor Erreichen der Betriebswerte soll also ausgeschlossen sein, z.B. indem die Steuerungseinrichtung das Erreichen der Betriebswerte überwacht bzw. prüft. Es ist hierzu bevorzugt in der Steuerung zu jedem Verdampfer die Information abgelegt, ob dieser die Betriebswerte erreicht hat, sodass diese Information das Erreichen oder Nichterreichen der Betriebswerte anzeigt. Vor dem Umschalten von einem ersten Verdampfer auf den zweiten Verdampfer des Verdampferpaares oder umgekehrt erfolgt z.B. zunächst die Abfrage der Information, und ein Umschalten erfolgt nur, wenn diese Information das Erreichen der Betriebswerte anzeigt. Es kann z.B. vorgesehen sein, dass entsprechende Flaggen gesetzt werden, die für die Steuerung erkennbar machen, ob ein Verdampfer noch in der Bereitstellungsphase ist oder die Bereitstellungsphase abgeschlossen hat und somit der Reserveverdampfer zu einem aktiven Verdampfer werden kann. Eine entsprechende Flagge oder eine entsprechende Information kann auch in einem Speicher des Verdampferpaares abgelegt sein und von einer Steuerung abgefragt werden.

Es wird weiterhin mit Vorteil vorgeschlagen, dass in einem Fehlerfall eines Verdampfers eines Verdampferpaares, der zum Zeitpunkt des Eintretens des Fehlerfalls ein bestimmtes Grundgas in die zugeordnete Grundgasleitung abgibt, automatisch der andere Verdampfer des Verdampferpaares das Abgeben dieses bestimmten Grundgases in die Grundgasleitung übernimmt. Damit übernehmen die beiden Verdampfer eines Paares eine gegenseitige Fehlerredundanz, sodass insgesamt nur noch wenige Konstellationen denkbar sind, dass kein Grundgas in die zugeordnete Grundgasleitung zugeführt werden kann.

Eine denkbare Konstellation wäre ein zeitgleicher Betriebsfehler in beiden Verdampfern, wobei theoretisch für diesen Fall ein dritter Verdampfer vorgesehen sein könnte. Allerdings ist eine solche Konstellation unwahrscheinlich, so dass das Vorsehen eines dritten Verdampfers als überzogen und nicht sinnvoll betrachtet wird, von der Erfindung aber auch nicht ausgeschlossen ist. Eine weitere denkbare Konstellation ist, dass bei Auftreten des Fehlerfalles in einem der Verdampfer des Verdampferpaares das Nachfüllen und das Herstellen der Betriebsbereitschaft im anderen Verdampfer noch nicht abgeschlossen ist. Eine bevorzugte Lösung hierfür könnte so aussehen, dass der zweite Verdampfer dennoch sofort mit der Grundgasleitung verbunden wird, also das Nachfüllen abgebrochen wird und z.B. das Nichterreichen der Betriebsbereitschaft ignoriert wird. Denkbar ist auch, dass das Abbrechen des Nachfüllens und das frühzeitige Umschalten davon abhängig gemacht wird, wie nahe die aktuellen Betriebswerte an den zu erreichenden Betriebswerten sind. Es können also Grenzwerte für diese Betriebswerte vorgegeben werden und anhand des Erreichens dieser Grenzwerte könnte entschieden werden, ob der zweite Verdampfer in einem Betriebszustand ist, der ein sofortiges Umschalten möglich macht oder ob ein solches sofortiges Umschalten nicht möglich ist. Auch dies könnte wie oben zur Anzeige der Betriebsbereitschaft umgesetzt werden durch Vorsehen einer entsprechenden zweiten Flagge bzw. zweiten Information, die von der Steuerung abgefragt wird, und die die Notfallbetriebsbereitschaft anzeigt.

Bezüglich des Nachfüllens irgendeines der Verdampfer ist vorteilhaft, dass dieses ausgeführt wird, wenn der Verdampfer einen Mindestfüllstand unterschreitet und/oder wenn auf den anderen Verdampfer des Verdampferpaares umgeschaltet wird. Damit ist einerseits gemeint, dass ein Nachfüllen nur dann erfolgen kann, wenn der andere Verdampfer des Verdampferpaares aktiv ist und das Einspeisen des Grundgases in die Grundgasleitung übernimmt. Der nachzufüllende Verdampfer muss also zum Zeitpunkt des Nachfüllens der Reserveverdampfer sein. Damit ist andererseits gemeint, dass das Unterschreiten eines Mindestfüllstandes erfasst wird, also z.B. ein Sensor vorgesehen und angeordnet ist, der diesen Füllstand erfasst. Der Sensor ist in die Steuerung der Gasversorgungsvorrichtung eingebunden und bei Erkennen des Erreichens bzw. des Unterschreitens des Mindestfüllstandes leitet die Steuerung das Umschalten auf den Reserveverdampfer ein und leitet nach erfolgtem Umschalten auf den Reserveverdampfer den Nachfüllvorgang für den ehedem aktiven Verdampfer ein. Diese beiden genannten Aspekte können zusammen oder alternativ vorgesehen sein.

Weitere für alle zuvor beschriebenen Ausführungsvarianten verallgemeinerungsfähige Verfahrens- und Vorrichtungseigenschaften sind z.B., dass die Betriebsbereitschaft eines Verdampfers nicht nur vom Erreichen der Betriebstemperatur und des Betriebsdruckes abhängig gemacht wird, sondern z.B. auch ein Füllstand an flüssigem Ausgangsfluid ermittelt wird, z.B. durch eine Gewichtserfassung und Vergleich mit einem erforderlichen Mindestgewicht. Denkbar ist auch, dass die Steuerung der Vorrichtung die Betriebsbereitschaft der Verdampfer abfragt, z.B. in ausreichend kurzer Taktung, und mit dem Umschalten auf den Reserveverdampfer wartet, bis Betriebsbereitschaft signalisiert ist. Es ist auch denkbar, dass das Gasversorgungsverfahren abgebrochen und die Gasversorgungsvorrichtung heruntergefahren wird, wenn über einen bestimmten Zeitraum der Reserveverdampfer keine Betriebsbereitschaft erreicht, aber der aktive Verdampfer einen Mindestfüllstand erreicht. Die Verdampfer können dabei jeweils auch so ausgeführt sein, dass diese selber an die Steuerung signalisieren, wenn trotz verstreichens einer bestimmten Zeitdauer der Betriebsdruck und/oder die Betriebstemperatur nicht erreicht werden konnten. Dieses Nichterreichen wäre wie ein Betriebsfehler zu werten und der entsprechende Verdampfer weist also eine Fehlfunktion auf. Die Funktion der beteiligten schaltbaren Ventile könnte überwacht werden und es könnten z.B. Fehlermeldungen ausgegeben werden, wenn die Schaltventile nicht von ihrer Ist-Stellung in eine Soll-Stellung überführt werden können, also z.B. nicht von der geschlossenen Stellung in die Offenstellung überführt werden können. Weiterhin könnte vor dem Ausführen des Nachfüllvorganges geprüft werden, welcher Füllstand in dem nachzufüllenden Verdampfer vorliegt und der Nachfüllvorgang z.B. nur ausgeführt werden, wenn ein bestimmter Füllstand unterschritten ist, ein Nachfüllen also überhaupt sinnvoll ist.

Möglich ist weiterhin, dass zu einem Produktionsbeginn zunächst eine Überprüfung erfolgt, ob und welche Verdampfer Betriebsbereitschaft erreicht haben. Es kann dann z.B. für den Produktionsbeginn der Verdampfer eines Verdampferpaares ausgewählt werden, der einerseits Betriebsbereitschaft anzeigt und andererseits den höheren Füllstand an Ausgangsfluid hat, während der andere Verdampfer des Verdampferpaares zunächst die Rolle des Reserveverdampfers übernimmt und gegebenenfalls weiter in Betriebsbereitschaft versetzt wird und/oder ein Nachfüllvorgang ausgeführt wird.

Es ist zu allen geschilderten Ausführungsvarianten vorteilhaft, wenn Statusmeldungen zu den Verdampfern auf einer Anzeigeeinrichtung der Vorrichtung einer Bedienperson angezeigt werden, insbesondere Statusmeldungen zu einer Betriebsbereitschaft oder dem Nichterreichen einer Betriebsbereitschaft oder zu Betriebsfehlern eines Verdampfers.

Nachfolgend wird die Erfindung anhand von bevorzugten Ausführungsbeispielen und anhand der beiliegenden Figuren näher erläutert. Die Zeichnungen sind nicht unbedingt maßstabsgetreu, sondern sie sind als Prinzipdarstellungen zu verstehen. In den Figuren sind gleiche oder im Wesentlichen funktionsgleiche bzw. -ähnliche Elemente mit den gleichen Bezugszeichen bezeichnet. Ohne Beschränkung der Allgemeinheit sind Flaschen ein typischer Anwendungsfall eines Behälters. Weiterhin wird nachfolgend zur Erläuterung der Erfindung insbesondere und ebenfalls ohne Beschränkung der Allgemeinheit auf Behälter aus einem thermoplastischen Kunststoff eingegangen, insbesondere auf Behälter aus PET, insbesondere wird eine Innenbeschichtung solcher Behälter beschrieben. Es zeigen:
- Fig. 1: eine schematische Aufsicht auf eine Beschichtungsanlage, wie sie im Grundaufbau und grundsätzlich im Stand der Technik bekannt ist;
- Fig. 2: eine perspektivische Ansicht auf ein erstes Beispiel für eine vereinzelte Beschichtungsstation, wie grundsätzlich im Stand der Technik bekannt;
- Fig. 3: eine Schnittansicht durch ein zweites Beispiel für eine vereinzelte Beschichtungsstation mit Doppelkammer und wie grundsätzlich im Stand der Technik bekannt;
- Fig. 4: eine perspektivische Ansicht auf den Grundaufbau einer beispielhaften Gasversorgungsvorrichtung für eine Beschichtungsvorrichtung;
- Fig. 5: eine Prinzipskizze zu den Vorgängen in einer Gasversorgungsvorrichtung am Beispiel von zwei Trägergasen und zwei Grundgasen, die durch Verdampfen von Monomeren bereitgestellt werden;
- Fig. 6: eine Prinzipdarstellung zu Einzelheiten einer beispielhaften Gasversorgungsvorrichtung mit zwei Verdampferpaaren, die jeweils nachfüllbar ausgeführt sind.

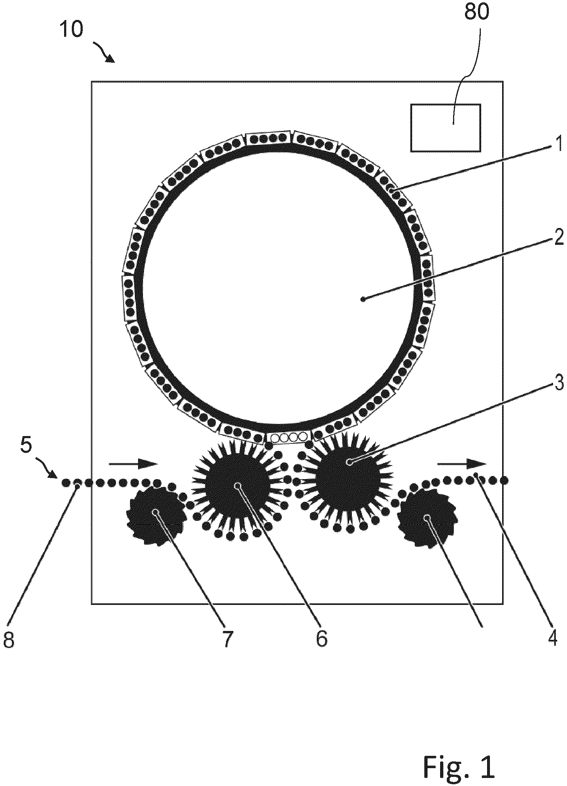

Aus der Darstellung in Fig. 1 ist eine Beschichtungsanlage, genauer gesagt eine PECVD-Anlage 10 zu erkennen, die mit einem rotierenden Plasmarad 2 versehen ist. Entlang eines Umfangs des Plasmarades 2 sind umfangsbeabstandet eine Mehrzahl von Plasmastationen 1 angeordnet. Die Plasmastationen 1 sind mit später noch gezeigten Kavitäten bzw. Plasmakammern 17 zur Aufnahme von zu behandelnden Werkstücken 5 versehen. Beispielhaft ist gezeigt, dass jede Plasmastation vier Behandlungsplätze aufweist. Diese PCVD-Anlage 10 steht rein exemplarisch für alle Beschichtungsanlagen, die unter Zuführung von Prozessgasen Beschichtungsprozesse ausführen. Weiterhin werden nachfolgend die Werkstücke lediglich beispielhaft von Behältern 5 gebildet, konkret von Flaschen.

Die zu behandelnden Behälter 5 werden dem Plasmarad 2 im Bereich einer Eingabe 8 zugeführt und über ein Vereinzelungsrad 7 an ein Übergaberad 6 weitergeleitet, das mit Tragarmen ausgestattet ist, die z.B. positionierbar ausgeführt sein können. Die Tragarme können z.B. relativ zu einem Sockel des Übergaberades 6 verschwenkbar angeordnet sein, so daß eine Abstandsveränderung der Behälter 5 relativ zueinander durchgeführt werden kann. Hierdurch erfolgt eine Übergabe der Behälter 5 vom Übergaberad 6 an das Plasmarad 2. Nach einer Durchführung der Behandlung während des Umlaufes auf dem Plasmarad 2 werden die behandelten Behälter 5 von einem Ausgaberad 3 aus dem Bereich des Plasmarades 2 entfernt und in den Bereich einer Ausgabestrecke 4 überführt.

Es sind im Stand der Technik die beiden Möglichkeiten bekannt, die z.B. als Behälter ausgebildeten Werkstücke 5 mit Mündungsbereich nach oben oder nach unten weisend zu beschichten. Ohne Beschränkung der Allgemeinheit wird in den nachfolgenden Abbildungen eine Positionierung des Behälters 5 mit Mündungsbereich nach unten weisend gezeigt. Möglich ist natürlich auch, dass die Behandlung auf dem Plasmarad mit Mündungsbereich nach oben weisenden erfolgt.

In nicht dargestellter Weise werden den mit dem Plasmarad 2 umlaufenden Plasmastationen 1 die für den Beschichtungsprozess notwendigen Prozessgase zugeführt. Die Zuführung erfolgt in der Regel in einem Zentrum des Plasmarades 2 und über einen dort angeordneten Drehverteiler, über den die Plasmastationen 1 auch mit weiteren Betriebsmitteln sowie Energie versorgt werden. Zur Betriebsmittelverteilung werden insbesondere Ringleitungen eingesetzt. Die auf das Plasmarad 2 übergebenen Prozessgase liegen bei der Übergabe in der erforderlichen Zusammensetzung vor und werden von einer außerhalb des Plasmarades 2 angeordneten Gasversorgungsvorrichtung bereitgestellt, zu der später ein Beispiel beschrieben wird.

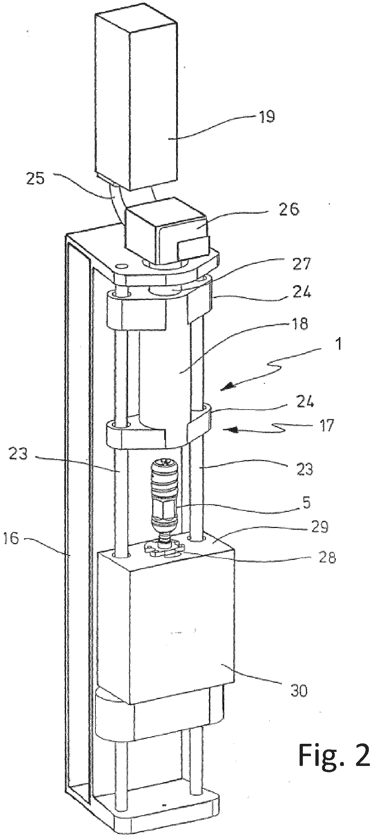

In Fig. 2 ist zur Erläuterung eines möglichen grundsätzlichen Aufbaus einer Plasmastation 1 in perspektivischer Darstellung eine Station mit einem Einzelbehandlungsplatz gezeigt. Ein Stationsrahmen 16 ist mit Führungsstangen 23 versehen, auf denen ein Schlitten 24 zur Halterung der zylinderförmigen Kammerwandung 18 geführt ist. Fig. 2 zeigt den Schlitten 24 mit Kammerwandung 18 in einem angehobenen Zustand, so daß das auf dem Kopf stehende Werkstück in Form eines Behälters 5 freigegeben ist. Im oberen Bereich der Plasmastation 1 ist ein Mikrowellengenerator 19 angeordnet. Der Mikrowellengenerator 19 ist über eine Umlenkung 25 und einen Adapter 26 an einen Kopplungskanal 27 angeschlossen, der in die Plasmakammer 17 einmündet. Der Adapter 26 hat die Funktion eines Übergangselementes. Die Umlenkung 25 ist als ein Hohlleiter ausgebildet. Der Behälter 5 wird im Bereich eines Dichtelementes 28 positioniert, das im Bereich eines Kammerbodens 29 angeordnet ist. Der Kammerboden 29 ist als Teil eines Kammersockels 30 ausgebildet.

Zum Schließen der Plasmakammer 17 kann der Schlitten 24 mit der zylinderförmigen Kammerwandung 18 entlang der Schienen 23 abgesenkt werden, bis die Kammerwandung 18 gegen den Kammerboden 29 gefahren ist. In diesem geschlossenen Positionierzustand kann die Plasmabeschichtung des dann in der geschlossenen Kavität 17 eingeschlossenen Behälters 5 durchgeführt werden. Im geschlossenen Positionierzustand erfolgt auch das Einstellen des in der Kammer 17 und des im Behälter 5 erforderlichen Unterdruckes, um ein Plasma zu erzeugen und mikrowelleninduziert die Plasmabeschichtung vorzunehmen. In der in Fig. 2 gezeigten angehobenen Positionierung der Kammerwandung 18 ist es ohne Probleme möglich, den behandelten Behälter 5 aus dem Bereich der Plasmastation 1 zu entfernen und einen neuen zu behandelnden Behälter 5 einzusetzen, z.B. mittels der in Figur 1 gezeigten Räder 6 und 3.

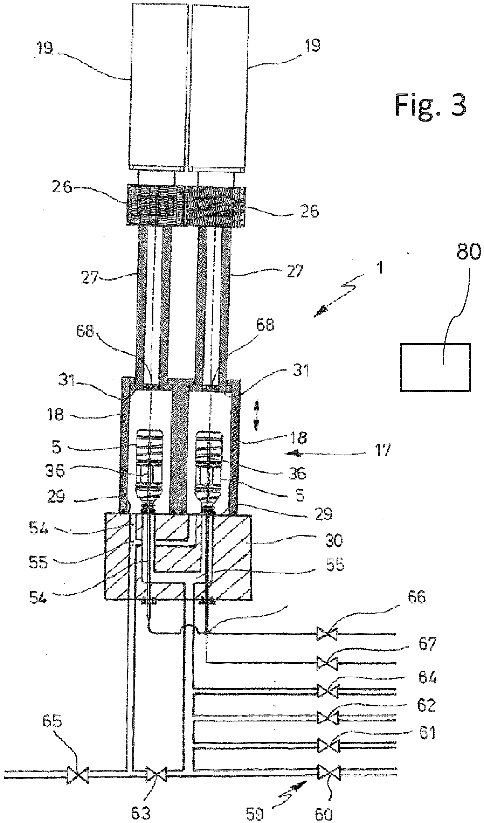

Fig. 3 zeigt ein alternatives Beispiel für eine Plasmastation 1 mit zwei Plasmakammern 17 zur gleichzeitigen Plasmabehandlung von zwei Behältern 5. Jede der Plasmakammern 17 ist über einen Kopplungskanal 27 sowie einen Adapter 26 und eine Umlenkung 25 an jeweils einen Mikrowellengenerator 19 angeschlossen. Grundsätzlich ist es ebenfalls denkbar, für zwei oder mehr Plasmakammern 17 einen gemeinsamen Mikrowellengenerator 19 zu verwenden und über eine nicht dargestellte Verzweigung eine Aufteilung der generierten Mikrowellenstrahlung vorzunehmen, um eine gleichmäßige Zündung des Plasmas in jeder der Plasmakammern 17 zu gewährleisten. Denkbar ist auch, dass zwischen den beiden Plasmakammern 17 keine Trennwand angeordnet wird und also eine Gesamtkammer mit zwei Behältern 5 vorgesehen ist.

In die Plasmakammern 17 münden Kopplungskanäle 54 ein, die jeweils an eine Verzweigung 55 zur Aufteilung einer Menge eines zugeführten Betriebsmittels in zwei Teilmengen angeschlossen sind. Bei einer Verwendung von mehr als zwei Plasmakammern 17 wird die Verzweigung 55 entweder mit einer entsprechenden Anzahl von Ausgängen versehen, oder es werden kaskadiert mehrere Teilverzweigungen hintereinander angeordnet. Über diese Kanäle 54, 55 kann z.B. Unterdruck zugeführt werden.

Zusätzlich eingezeichnet ist eine Gaslanze 36, die in vertikaler Richtung in den Behälter 5 hineingefahren und herausgeführt werden kann, z.B. in nicht dargestellter Weise durch Anordnung an einem Lanzenschlitten, der in vertikaler Richtung geführt und z.B. kurvengesteuert eine Vertikalbewegung ausführen kann. In der dargestellten Positionierung ist die Plasmakammer 17 geschlossen und die Lanze 36 innerhalb des Behälters 5 angeordnet für das Austragen der Prozessgase in den Innenraum des Behälters 5.

Im Bereich des Kammersockels 30 erfolgt über die schon angesprochenen Kanäle 54, 55 die Beaufschlagung der Plasmakammern 17 und der Behälter 5 mit Unterdruck. Prozessgase werden über eine von den Ventilen 66 und 67 beherrschte Leitungen der Gaslanze 36 zugeführt und in das Behälterinnere geleitet. Die Zuführung all dieser Betriebsmittel erfolgt ventilgesteuert. Die von den Ventilen 66 und 67 beherrschten Leitungen stehen in Verbindung mit einer später beschriebenen Gasversorgungsvorrichtung und führt die von dieser Gasversorgungsvorrichtung bereitgestellten Prozessgase zur Gaslanze 36.

Fig. 3 zeigt in einer stark schematisierten Darstellung sowie mit zusätzlicher Darstellung von Ventilen 59 die Steuerung einer Betriebsmittelzufuhr. Beim dargestellten Ausführungsbeispiel sind aufgrund der schaltungstechnischen Anordnung der Kopplungskanäle 54 drei Verzweigungen 55 verwendet. Zu erkennen sind ebenfalls Quarzglasfenster 68 zur Abdichtung der Innenräume der Plasmakammern 17 relativ zu den Innenräumen der Kopplungskanäle 27 bei gleichzeitiger Durchtrittsmöglichkeit für die Mikrowellenstrahlung.

Gemäß der gezeigten, rein beispielhaften Ausführungsform werden ein Primärvakuumventil 60 zur Zuführung einer ersten Unterdruckstufe sowie ein Sekundärvakuumventil 61 zur Zuführung eines gegenüber der ersten Unterdruckstufe niedrigeren Unterdruckes verwendet. Das Hinzutreten weiterer Unterdruckstufen ist möglich. Zur Aufrechterhaltung des Vakuums synchron zur Zuführung des Prozessgases ist darüber hinaus ein Prozessvakuumventil 62 angeordnet. Das Prozessvakuumventil 62 vermeidet einen Übertritt von abgesaugtem Prozessgas in die Versorgungskreise für das Primärvakuum und das Sekundärvakuum.

Zur Unterstützung einer wahlweisen oder gemeinsamen Zuführung von Unterdruck zum Innenraum des Behälters 5 und/oder in den weiteren Innenraum der Plasmakammer 17 ist ein Kammervakuumventil 63 verwendet, das eine entsprechende Absperrfunktion durchführt. Insbesondere ist daran gedacht, das jeweilige Versorgungsvakuum über die Ventile 60, 61, 62 jeweils unmittelbar dem Innenraum des Behälters 5 zuzuführen und über das Kammervakuumventil 63 gesteuert eine bedarfsabhängige Zuschaltung des weiteren Innenraumes der Plasmakammer 17 vorzunehmen.

Für eine vorgebbare und voneinander unabhängige Entlüftung sowohl des Innenraumes des Behälters 5 als auch des weiteren Innenraumes der Plasmakammer 17 wird ein Behälterentlüftungsventil 64 sowie ein Kammerentlüftungsventil 65 verwendet. Für eine Zuführung unterschiedlicher Prozessgaszusammensetzungen wird ein Primärprozessgasventil 66 sowie ein Sekundärprozessgasventil 67 verwendet. Denkbar ist auch das Zuführen weiterer Prozessgasmischungen, sodass weitere Leitungen und weitere Ventile hinzutreten könnten. Die Bereitstellung der Prozessgasmischungen erfolgt durch eine später beschriebene Gasversorgungsvorrichtung.

Ein typischer Behandlungsvorgang wird z.B. derart durchgeführt, dass zunächst der Behälter 5 wie zu Figur 1 erläutert zum Plasmarad 2 transportiert wird und das Einsetzen des Behälters 5 in die Plasmastation 1 in einem hochgeschobenen Zustand der hülsenartigen Kammerwandung 18 erfolgt. Nach einem Abschluss des Einsetzvorganges wird die Kammerwandung 18 in ihre abgedichtete Positionierung abgesenkt und zunächst gleichzeitig eine Evakuierung sowohl der Kavität 17 als auch eines Innenraumes des Behälters 5 durchgeführt, ggf. erfolgt zunächst auch nur eine Vorevakuierung der Kavität 17, bevor auch die Evakuierung des Innenraums des Behälters 5 zugeschaltet wird.

Nach einer ausreichenden Evakuierung des Innenraumes der Kavität 17, oder aber auch schon zuvor, wird die Lanze 36 in den Innenraum des Behälters 5 eingefahren und eine Abschottung des Innenraumes des Behälters 5 gegenüber dem Innenraum der Kavität 17 durchgeführt. Ebenfalls ist es möglich, die Lanze 36 bereits synchron zur beginnenden Evakuierung des Innenraumes der Kavität 17 in den Behälter 5 hineinzuverfahren. Der Druck im Innenraum des Behälters 5 wird anschließend noch weiter abgesenkt. Darüber hinaus ist auch daran gedacht, die Positionierbewegung der Lanze 36 wenigstens teilweise bereits parallel zur Positionierung der Kammerwandung 18 durchzuführen. Nach Erreichen eines ausreichend tiefen Unterdruckes wird Prozessgas in den Innenraum des Behälters 5 eingeleitet und mit Hilfe des Mikrowellengenerators 19 das Plasma gezündet. Insbesondere ist daran gedacht, mit Hilfe des Plasmas sowohl einen Haftvermittler auf eine innere Oberfläche des Behälters 5 als auch die eigentliche Barriereschicht aus Siliziumoxiden abzuscheiden. Eine zusätzliche dritte Schicht, zum Beispiel eine Schutzschicht, könnte ebenfalls mit Hilfe des Plasmas abgeschieden werden, z.B. ebenfalls aus Siliziumoxiden.

Nach einem Abschluss des Beschichtungsvorganges wird die Lanze 36 wieder aus dem Innenraum des Behälters 5 entfernt und die Plasmakammer 17 sowie der Innenraum des Behälters 5 werden belüftet. Denkbar ist auch, erst zu belüften und anschließend die Lanze herauszufahren. Nach Erreichen des Umgebungsdruckes innerhalb der Kavität 17 wird die Kammerwandung 18 wieder angehoben, um eine Entnahme des beschichteten Behälters 5 sowie eine Eingabe eines neuen zu beschichtenden Behälters 5 durchzuführen. Das geschilderte Beschichtungsverfahren läuft ab, während der Behälter 5 in der Plasmastation 1 auf dem Plasmarad 2 umläuft.

Eine Positionierung der Kammerwandung 18 und/oder der Lanze 36 kann unter Verwendung unterschiedlicher Antriebsaggregate erfolgen. Grundsätzlich ist die Verwendung pneumatischer Antriebe und/oder elektrischer Antriebe, insbesondere in einer Ausführungsform als Linearmotor, denkbar. Insbesondere ist aber daran gedacht, zur Unterstützung einer exakten Bewegungskoordinierung mit einer Rotation des Plasmarades 2 eine Kurvensteuerung zu realisieren. Die Kurvensteuerung kann beispielsweise derart ausgeführt sein, dass entlang eines Umfanges des Plasmarades 2 Steuerkurven angeordnet sind, entlang derer Kurvenrollen geführt werden. Die Kurvenrollen sind mit den jeweils zu positionierenden Bauelementen gekoppelt.

Die Betätigung der Ventile 59 erfolgt vorzugsweise über eine programmierbare elektronische Steuerung 80. Zunächst wird nach einem Schließen der Plasmakammer 17 das Primärvakuumventil 60 geöffnet und der Innenraum des Behälters 5 und der Innenraum der Plasmakammer 17 gleichzeitig oder teilweise zeitlich versetzt evakuiert. Hierbei wird ein Druckniveau z.B. im Bereich von 20 mbar bis 50 mbar erreicht. Nach einem Schließen des Primärvakuumventils 60 erfolgt ein Öffnen des Sekundärvakuumventils 61 und der Innenraum des Behälters 5 und der Innenraum der Plasmakammer 17 werden zunächst gleichzeitig an eine Unterdruckquelle mit einem niedrigeren Druckniveau angeschlossen. Nach einer ausreichenden Evakuierung des den Behälter 5 umgebenden Innenraumes der Plasmakammer 17 schließt das Kammervakuumventil 63 und lediglich der Innenraum des Werkstückes 5 wird weiter evakuiert. Hierbei wird z.B. ein Druckniveau von etwa 0,1 mbar erreicht.

Nach einem Schließen des Kammervakuumventils 63 und einer in der Regel bereits zuvor erfolgten Positionierung der Lanze 36 innerhalb des Innenraumes des Behälters 5 öffnet das Primärprozessgasventil 66 und ein Prozessgas einer ersten Zusammensetzung wird zugeführt. Nach einer ausreichenden Prozessgaszuführung zündet der Mikrowellengenerator 19 das Plasma im Innenraum des Behälters 5. Zu einem vorgebbaren Zeitpunkt schließt das Primärprozessgasventil 66 und das Sekundärprozessgasventil 67 öffnet zur Zuführung eines Prozessgases einer zweiten Zusammensetzung. Zumindest zeitweise parallel zum Öffnen der Prozessgasventile 66, 67 öffnet auch das Prozessvakuumventil 62, um einen ausreichend niedrigen Unterdruck im Innenraum des Behälters 5 aufrecht zu erhalten. Hierbei erweist sich ein Druckniveau von z.B. etwa 0,3 mbar als zweckmäßig Nach einem Abschluss der Plasmabeschichtung öffnet zunächst das Behälterentlüftungsventil 64 und schließt den Innenraum des Behälters 5 an einen Umgebungsdruck an. Mit einer vorgebbaren zeitlichen Verzögerung nach einem Öffnen des Behälterentlüftungsventils 64 öffnet auch das Kammerentlüftungsventil 65, um den Innenraum der Plasmakammer 17 wieder vollständig auf den Umgebungsdruck anzuheben. Nach einem zumindest annäherungsweisen Erreichen des Umgebungsdruckes innerhalb der Plasmakammer 17 kann die Plasmakammer 17 öffnen und der beschichtete Behälter 5 wird entnommen und durch einen neuen zu beschichtenden Behälter 5 ersetzt.

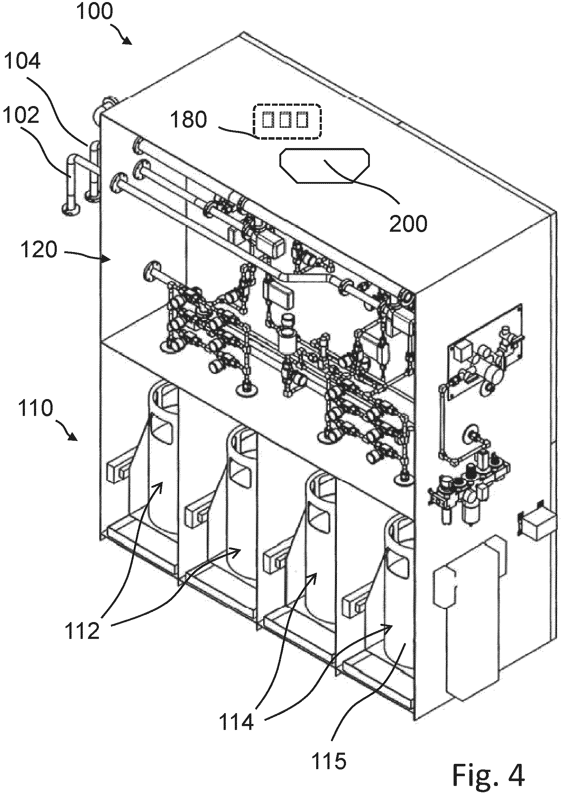

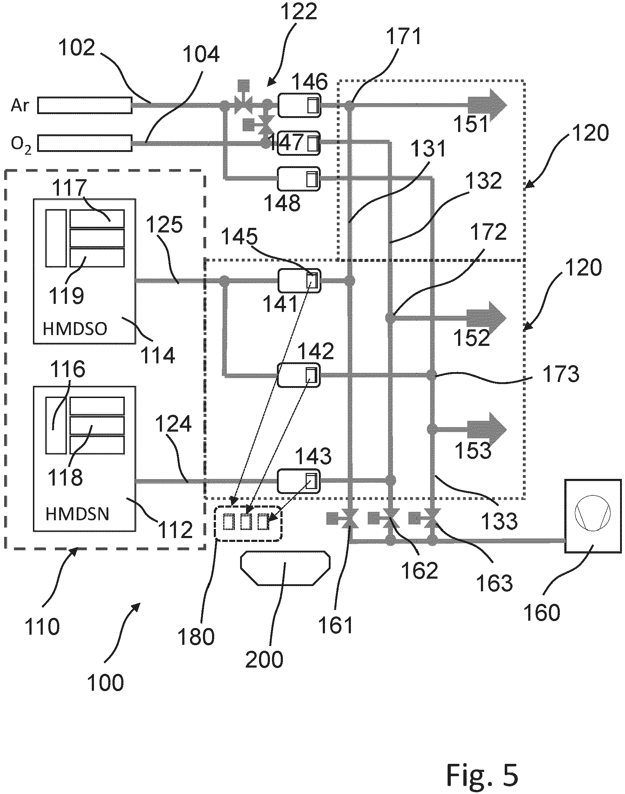

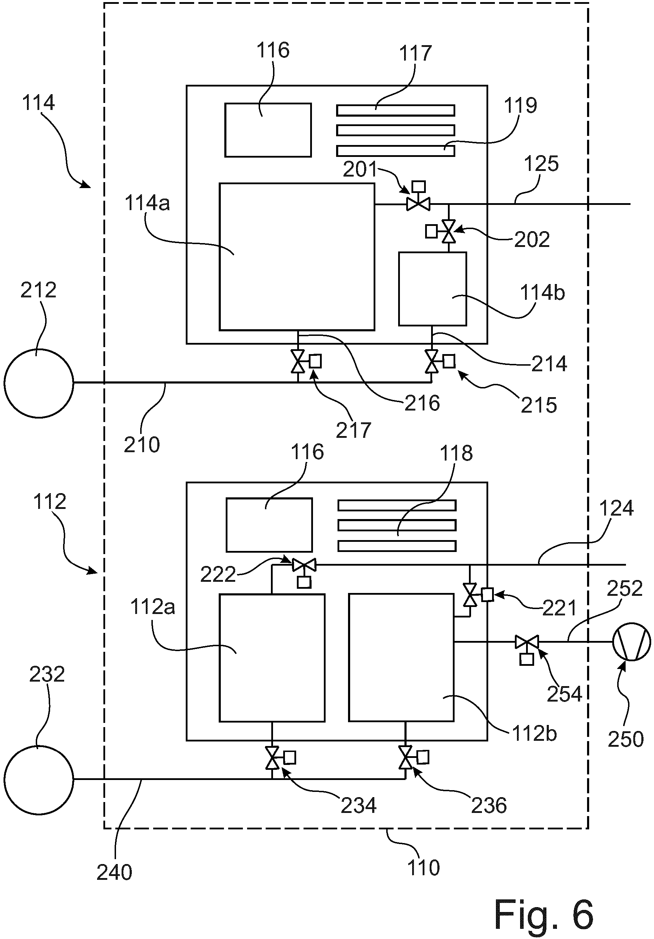

Die Bereitstellung der Prozessgase für eine beispielhaft wie oben beschriebene Beschichtungsanlage und für beispielhaft wie oben beschrieben ablaufende Beschichtungsprozesse übernimmt eine nachfolgend zu beschreibende Gasversorgungsvorrichtung 100. Figur 4 zeigt ein beispielhaftes Aussehen und einen beispielhaften Grundaufbau einer solchen Gasversorgungsvorrichtung 100. Figur 5 zeigt in einer Prinzipskizze, welche Vorgänge in einer solchen Gasversorgungsvorrichtung 100 ablaufen und wie eine Anordnung hierfür eingesetzter Leitungen und Dosiereinrichtungen mit Vorteil erfolgt. Figur 6 zeigt weitere Details zu den Verdampfern und zu deren Nachbefüllung.

Die in Figur 4 dargestellte Gasversorgungsvorrichtung 100 ist ausgeführt in Form eines Schrankes mit Seiten- und Rückwänden und mit Schranktüren im Frontbereich, die nicht gezeigt sind, um einen Blick ins Vorrichtungsinnere zu erlauben. Diese Wände begrenzen also Kammern bzw. Teilkammern der Gasversorgungsvorrichtung 100. In diesen Kammern verlaufen Leitungen und sind Einrichtungen der Gasversorgungsvorrichtung angeordnet, z.B. Einrichtungen, um Grundgase zu führen, um das Strömen der Gase zu beherrschen, um Grundgase zu dosieren, um Grundgase miteinander zu mischen und/oder um Grundgase aus Precursor-Flüssigkeiten zu erzeugen.

Der Gasversorgungsschrank 100 ist im dargestellten Beispiel in vertikaler Richtung unterteilt in einen Unterschrank 110 und einen Oberschrank 120. Im Unterschrank 110 sind im dargestellten Ausführungsbeispiel vier mit einer Precursor-Flüssigkeit gefüllte Verdampfer in Form von Fässern 112, 114 angeordnet, welche im gezeigten Beispiel durch Vertikalwände voneinander getrennt sind. Die beiden auf der linken Seite der Darstellung gezeigten Fässer 112 bilden ein erstes Verdampferpaar und sollen z.B. HMDSN enthalten, und die beiden auf der rechten Seite der Darstellung gezeigten Fässer 114 bilden ein zweites Verdampferpaar und sollen HMDSO enthalten. Alle Fässer sind in der gleichen Weise mit einer Heizeinrichtung versehen, z.B. wie im Stand der Technik beschrieben. Vorliegend sind die Fässer 112, 114 jeweils von einer Heizmanschette 115 umgeben und eine Temperatursteuerung 116 regelt die Heizleistung der jeweiligen Heizeinrichtung 115 so, dass das in den Fässern 112, 114 aufgenommene Precursor in den gasförmigen Zustand überführt wird. Es gelten die Ausführungen in der allgemeinen Beschreibung über vorteilhafte Temperaturen, die von diesen Heizeinrichtungen 115 zusammen mit der Temperatursteuerung 116 eingestellt werden. Es gilt ebenfalls die Aussage im allgemeinen Beschreibungsteil, dass nicht zwischen einer Steuerung und eine Regelung unterschieden wird.

In dem Oberschrank 120 vertikal oberhalb des Unterschrankes 110 mit den Verdampfern 112, 114 sind diverse Leitungen, Armaturen, Ventile und Dosiermittel angeordnet, um die durch Verdampfen der Precursor bereitgestellten Grundgase zu leiten, zu dosieren und zu mischen, z.B. mit weiteren Grundgasen, die über Zuführleitungen 102, 104 seitlich links von der Gasversorgungsvorrichtung 100 in die obere Teilkammer 120 hineingeführt werden. Bei diesen schon gasförmig vorliegenden weiteren Grundgasen handelt es sich z.B. um Sauerstoff und Argon. Aus diesen bereits gasförmig der Gasversorgungsvorrichtung 100 zugeführten Grundgasen sowie aus den durch Verdampfen von HMDSN und HMDSO entstehenden Grundgasen lassen sich Gasmischungen bereitstellen, um in der zuvor beschriebenen Beschichtungsanlage 10 auf der Innenwand eines Behälters 5 zeitlich nacheinander mehrere Schichten abzuscheiden, z.B. zunächst eine Haftvermittlerschicht, dann eine Barriereschicht und schließlich eine Schutzschicht. Andere Schichtaufbauten und andere Anzahlen von Schichten sind möglich. Die Teilkammer 120 mit den Leitungen, Armaturen, Ventilen und Dosiermitteln kann z.B. insgesamt als Warmbereich bzw. Warmkammer ausgeführt sein, so wie in der allgemeinen Beschreibung erläutert. Bevorzugt werden aber bestimmte Elemente außerhalb eines solchen Warmbereiches angeordnet, wie anhand der Prinzipskizze in Figur 5 verdeutlicht ist.

In Übereinstimmung mit dem Beispiel in Figur 4 werden über Zuführleitungen 102, 104 die Gase Argon und Sauerstoff in gasförmiger Form der Gasversorgungsvorrichtung 100 zugeführt. Diese Gase dienen z.B. als Trägergase, Sauerstoff nimmt aber auch am Abscheieprozess teil. Die flüssigen Precursor HMDSO und HMDSN sind in jeweiligen Verdampferpaaren 112, 114 aufgenommen. Diese Verdampferpaare 112, 114 bestehen jeweils aus zwei Verdampfern 112a, 112b bzw. 114a, 114b, wie später Figur 6 zeigt. Jeder Verdampfer ist dabei z.B. ausgestattet mit einem Temperatursensor 117 und/oder einem Drucksensor 118 und/oder einem Füllstandssensor 119. Weiterhin weist jedesVerdampferpaar 112, 114 eine Steuerungseinrichtung 116 auf, um die in den Verdampfern 112a, b und 114a, b enthaltene Flüssigkeit auf eine gewünschte Temperatur zu erhitzen. Beide genannten Beispiele für eine Precursorflüssigkeit weisen eine Siedetemperatur von 45 °C auf und die Erwärmung erfolgt bis mindestens auf diese Siedetemperatur, bevorzugt auf eine Temperatur oberhalb dieser Siedetemperatur. Es wird zu vorteilhaften Temperaturen auf die allgemeine Beschreibung verwiesen.

Aus Gründen der Übersichtlichkeit sind in Figur 5 nur einige schaltbare Ventile 122 dargestellt. Es versteht sich, dass weitere Ventile 122 vorgesehen sein können, um den Gasstrom in den diversen Gasleitungen zu beherrschen.

Die genannten Verdampferpaare 112, 114 mit HMDSO bzw. HMDSN sind wie in Figur 4 dargestellt im Unterschrank 110 angeordnet. Von den Verdampferpaaren 112, 114 führen Grundgasleitungen 124, 125 bis in den davon getrennten Oberschrank 120, der als Warmbereich 120 bzw. Warmkammer 120 ausgebildet ist, wie in der allgemeinen Beschreibung erläutert. Die in diesem Warmbereich 120 verlaufenden Leitungen 124, 125, 131, 132, 133 und die in diesem Bereich angeordneten Dosiermittel 141, 142, 143, wie z.B. MFC's, sollen auf einer Temperatur gehalten sein, die oberhalb der Siedetemperatur der in den Verdampferpaaren 112, 114 aufgenommenen Precursor liegen bzw. oberhalb der Temperaturen liegen sollen, auf denen die Precursor in den Verdampferpaaren 112, 114 gebracht werden. Bevorzugt soll ein zusätzlicher Temperaturunterschied von 5 °C eingestellt sein, d. h. der Oberschrank 120 bzw. der Warmbereich 120 soll auf eine um 5 °C höhere Temperatur gehalten sein, als die Siedetemperatur bzw. die Aufheiztemperatur.

Im rechten Bereich der Figur 5 ist angedeutet, dass drei Prozessgasmischungen 151, 152, 153 bereitgestellt werden sollen, wobei diese Prozessgasmischungen in nicht dargestellter Weise einer Beschichtungsanlage 10 zugeführt werden, z.B. über in Figur 3 dargestellten Leitungen mit den Ventilen 66 und 67, wobei für die dritte Prozessgasmischung eine weitere Leitung mit einem weiteren Ventil hinzutreten könnte.

Weiterhin ist in Figur 5 in einer als Beispiel aufzufassenden Anordnung eine Vakuumpumpe 160 dargestellt, die über jeweilige Schaltmittel, z.B. Magnetventile 161, 162, 163, Vakuum auf die Leitungen 131, 132, 133 geben kann, in denen die drei genannten Prozessgasmischungen 151 152, 153 aus der Gasversorgungsvorrichtung 100 herausgeführt werden. Auf diese Weise kann ein Bypassweg bereitgestellt werden, um nicht von der Beschichtungsvorrichtung 10 abgenommene Gasmengen abzusaugen, z.B. in den Phasen, in denen ein Behälterwechsel erfolgt, oder in den Phasen, in denen andere Prozessgasmischungen abgenommen werden. Solche Bypassleitungen sind im Stand der Technik vielfältig bekannt.

Die der Gasversorgungsvorrichtung 100 in gasförmiger Form zugeführten Grundgase (Argon, Sauerstoff) werden von zugeordneten Dosiermitteln, beispielsweise MFC's 146, 147, 148, dosiert Mischbereichen 171, 172, 173 zugeführt. Im dargestellten Beispiel sind die MFC mit den Bezugszeichen 146, 147, 148 diesen Grundgasen zugeordnet. Diese MFC 146, 147, 148 sind außerhalb des Warmbereiches 120 angeordnet, da diese MFC 146, 147, 148 nicht auf erhöhter Temperatur gehalten werden müssen, denn ein Kondensieren des geführten Gases kann nicht eintreten: die dort strömenden Gase liegen bei den üblichen Raumtemperaturen in Gasform vor. Die MFC mit Bezugszeichen 141, 142, 143, welche der Dosierung der Grundgase dienen, die nach Verdampfen aus den Precursern entstehen, sind hingegen im Warmbereich 120 angeordnet. Dies erfolgt, um ein Kondensieren dieser Grundgase in den Leitungen 131, 132, 1333 und/oder in den Dosiermitteln 141, 142, 143 zu verhindern.

Jedes der dargestellten MFC 141, 142, 143, 146, 147, 148 ist jeweils ausgestattet mit einer jeweiligen Steuerelektronik 145. Die jeweiligen Steuerelektroniken 145 der MFC 141, 142, 143 sind optional und mit Vorteil beabstandet von den davon gesteuerten MFC 141, 142, 143 angeordnet, siehe Anordnung im gestrichelte Bereich 180, und die Anordnung dieser beabstandet von den MFC 141, 142, 143 vorgesehenen Steuerelektroniken 145 erfolgt außerhalb des Warmbereiches 120. Zu den MFC 146, 147, 148 ist dargestellt, dass deren Steuerelektronik 145 jeweils unmittelbar bei den MFC 146, 147, 148 verbleiben. Denkbar ist aber auch, dass auch diese Steuerelektroniken 145 beanstandet von den MFC 146, 147, 148 angeordnet werden und z.B. gemeinsam mit den anderen Steuerelektroniken 145 im Bereich 180 angeordnet werden, um dort eine Steuereinheit 180 mit allen Steuerelektroniken 145 der MFC 141, 142, 143, 146, 147, 148 auszubilden. Diese Steuereinheit 180 könnte z.B. klimatisiert ausgeführt sein und/oder in räumlicher Nähe zu der Steuereinrichtung 200 der Gasversorgungsvorrichtung 100 oder zu einer Steuereinrichtung 80 der Beschichtungsanlage 10 angeordnet werden.

Wie weiterhin aus Figur 5 erkennbar, führen die Grundgasleitungen 102, 104 der Trägergase stromabwärts der MFC 146, 147, 148 in den Warmbereich hinein bis hin zu Mischbereichen 171, 172, 173, die als Kreuzungspunkte ausgeführt sind, in denen unterschiedliche Grundgase führende Grundgasleitungen zusammenlaufen. An diesem Kreuzungspunkten 171, 172, 173 werden Grundgase zusammengeführt, die einerseits bereits in gasförmiger Form vorlagen (Argon, Sauerstoff) und die andererseits durch Verdampfen von Precursern erzeugt wurden. Aus diesem Grunde ist das Anordnen dieser Mischbereiche 171, 172, 173 bzw. der Kreuzungspunkte im Warmbereich vorteilhaft, um auch in diesen Mischbereichen 171, 172, 173 und den in Strömungsrichtung nachfolgenden Leitungen ein Kondensieren zu vermeiden.

Anhand der nachfolgenden Figur 6 soll an einem Ausführungsbeispiel gezeigt und erklärt werden, wie in bevorzugter Weise ein Verdampferpaar 112 oder 114 ausgestaltet werden kann. Dabei sind bewusst die beiden Verdampferpaare 112 und 114 unterschiedlich ausgeführt, um anhand einer Abbildung zwei Ausgestaltungsvarianten darstellen zu können.

In der oberen Bildhälfte der Figur 6 ist das Verdampferpaar 114 gezeigt, bestehend aus einem ersten Verdampfer 114a und einem zweiten Verdampfer 114b. Beide können z.B. in der Art eines Fasses ausgebildet sein, wie in Figur 4 gezeigt, das heißt beide sind zur Aufnahme einer Ausgangsflüssigkeit geeignet ausgebildet. Es ist angedeutet, dass das Fassungsvermögen des ersten Verdampfers 114a deutlich größer ist als das Fassungsvermögen des Verdampfers 114b. Dieses Beispiel soll eine Variante darstellen, die im allgemeinen Beschreibungsteil als möglich, aber weniger vorteilhaft erwähnt ist, wonach nämlich z.B. der zweite Verdampfer 114b hauptsächlich als Reserveverdampfer vorgesehen ist und um bei Betriebsstörungen des ersten Verdampfer 114a einspringen zu können. Der Verdampfer 114a soll hingegen die überwiegende Zeit die Gasversorgung sicherstellen und nur im Fehlerfall oder während notwendiger Nachfüllphasen soll der Reserveverdampfer 114b ersatzweise einspringen. Beide Verdampfer 114a, 114b können ventilbeherrscht mit der zugeordneten Grundgasleitung 125 verbunden werden und im verbundenen Zustand in diese Grundgasleitung 125 durch Verdampfen der Ausgangsflüssigkeit ein Grundgas einspeisen. Die entsprechenden Verbindungsleitungen zur Grundgasleitung 125 sind von schaltbaren Ventilen 201, 202 beherrscht. Schaltvorgänge der Ventile 201 und 202 und gegebenenfalls eine Überwachung des Schaltzustandes der Ventile 201, 202 übernimmt die mit Bezugszeichen 116 versehene Steuereinrichtung. Beide Verdampfer 114a, 114b sollen so betrieben sein, dass sie den gleichen Betriebsdruck und die gleiche Betriebstemperatur anstreben und bei Erreichen dieser Betriebswerte diese beizubehalten versuchen. Die Verdampfer 114a, 114b weisen entsprechende und entsprechend angeordneten Sensoren auf, wobei zur vereinfachenden zeichnerischen Darstellung nur ein entsprechender Temperatursensor 117 und ein entsprechender Drucksensor 118 schematisch gezeigt ist. Auch ein Füllstandssensor 119 ist lediglich schematisch gezeigt.

Beide Verdampfer 114a und 114b sind zudem über eine Nachfüllleitung 210 an ein Reservoir 212 für die Ausgangsflüssigkeit anschließbar. Die Anschlussleitungen 214, 216 der Verdampfer 114a, 114b verlaufen ventilbeherrscht zu dieser Nachfüllleitung 210 hin. Auch diese Ventile 215, 217 sind von der Steuereinrichtung 116 schaltbar ausgeführt, d. h. die Steuereinrichtung 116 steuert, ob und wann aus dem Reservoir 212 der Precursor in den Verdampfer 114a oder 114b einströmen kann.

Die Verdampfer 112a und 112bsind grundsätzlich ähnlich ausgebildet zu den Verdampfern 114a und 114b, wobei die beiden Verdampfer 112a und 112b mit einem anderen flüssigen Precursor befüllt sind und eine andere Grundgasleitung 124 mit Grundgas beaufschlagen können, sobald entsprechende Schaltventile 221, 222 den Zustrom in die Grundgasleitung 124 freigegeben. Analog zu dem Verdampferpaar 114 ist auch das zweite Verdampferpaar 112 an ein Reservoir 232 für die zweite Ausgangsflüssigkeit angeschlossen, wobei das Zuströmen des zweiten Precursors aus dem Reservoir 232 von schaltbaren Ventilen 234 und 236 beherrscht wird, die z.B. ebenfalls von der Steuereinrichtung 116 angesteuert werden. Im Unterschied zu den Verdampfern 114a und 114b sollen die Verdampfer 112a und 112b identische Mengen an Ausgangsfluid aufnehmen können, sodass die Verdampfer 112a und 112b untereinander identisch aufgebaut und identisch ausgeführt sein können. Auch die Verdampfer 112a und 112b sollen für das Erreichen von Betriebswerten in Bezug auf Druck und Temperatur und für das Beibehalten dieser Betriebswerte betrieben werden. Die Betriebswerte dieses Verdampferpaares 112 können von den Betriebswerten des zuvor beschriebenen Verdampferpaares 114 abweichen, da verschiedene Ausgangsflüssigen vorliegen und verdampft werden.

Anhand des Verdampferpaares 112 und anhand von Figur 6 soll exemplarisch ein Verfahrensablauf geschildert werden, der das Zusammenspiel der beiden Verdampfer 112a, 112b des Verdampferpaares 112 verdeutlichen soll. In der allgemeinen Beschreibung sind Verfahrensalternativen und Verfahrensergänzungen beschrieben.

Zunächst soll rein beispielhaft der Verdampfer 112a als aktiver Verdampfer arbeiten, d. h. das Ventil 222 befindet sich im geöffneten Zustand und im Verdampfer 112a sind die gewünschten Betriebswerte erreicht, das heißt es wird das aus dem Precursor durch Verdampfen erzeugte Grundgas in die Grundgasleitung 124 eingespeist und der weiteren Verwendung zugeführt. Das Ventil 221 befindet sich im geschlossenen Zustand und der Verdampfer 112b hat die Rolle des Reserveverdampfers eingenommen. Soweit z.B. der Reserveverdampfer 112b nicht vollständig mit dem Precursor befüllt ist und dies z.B. von der Steuereinrichtung 116 anhand des Füllstandssensors 119 festgestellt wird, wird das zugeordnete Nachfüllventil 236 in den geöffneten Zustand gesteuert und über die Nachfüllleitung 240 kann aus dem Reservoir 232 die Ausgangsflüssigkeit in den Verdampfer 112b einströmen. Zeitgleich kann eine nicht dargestellte Heizeinrichtung, z.B. eine in dem Precursor im Verdampfer angeordnete Heizspirale, das Erwärmen des Precursors bis über die Siedetemperatur ausführen und die Vakuumpumpe 250 kann über die Pumpleitung 252 bei geöffnetem Pumpventil 254 die gewünschten Unterdruckbedingungen einstellen. Ist das Nachfüllen abgeschlossen, und der Füllstandssensor 119 zeigt z.B. den gewünschten maximalen Füllstand an, so schließt das Nachfüllventil 236, während die Steuereinrichtung 116 die Heizeinrichtung und die Pumpeinrichtung 250 weiterhin so ansteuert, dass die gewünschten Betriebswerte angestrebt werden. Sind diese Betriebswerte erreicht, kann z.B. in der Steuereinrichtung 116 eine Flagge gesetzt werden, dass der Verdampfer 112b betriebsbereit ist und den Verdampfer 112a ablösen kann.

Wenn im Verdampfer 112a eine Betriebsstörung eintritt oder wenn der Füllstand im Verdampfer 112a so weit abgesunken ist, dass ein Nachfüllvorgang erforderlich ist, steuert die Steuereinrichtung 116 die beiden Verdampfer 112a und 112b des Verdampferpaares 112 zu einem Umschalten an. Zunächst wird z.B. das Grundgasventil 222 in den geschlossenen Zustand überführt und das Grundgasventil 221 in den geöffneten Zustand überführt. Fortan strömt also Grundgas nicht mehr aus dem Verdampfer 112a, sondern aus dem ehemaligen Reserveverdampfer 112b in die Grundgasleitung 124. Der ehemalige Reserveverdampfer 112b ist nunmehr der aktive Verdampfer, während der ehemals aktive Verdampfer 112a zum Reserveverdampfer wird. Ist für den Verdampfer 112a ein Nachfüllvorgang erforderlich, so öffnet die Steuereinrichtung 116 das zugeordnete Nachfüllventil 234, sodass durch die Nachfüllleitung 240 hindurch der Precursor aus dem Reservoir 232 in den Verdampfer 112a einströmen kann. Auch der Verdampfer 112aweist eine Heizeinrichtung auf, z.B. in Form einer Heizspirale innerhalb des Behälters für den Precursor, und eine nicht dargestellte Pumpeinrichtung, um erforderliche Unterdruckbedingungen einzustellen. Ist der gewünschte Füllstand im Verdampfer 112a erreicht, so wird das Nachfüllventil 234 in den geschlossenen Zustand gesteuert, während die Heizeinrichtung und die Pumpeinrichtung weiter so betrieben werden, dass die Betriebswerte angestrebt oder - soweit bereits erreicht - beibehalten werden. Der Verdampfer 112a ist bei Erreichen dieser Betriebswerte betriebsbereit und in der Steuereinrichtung 116 kann eine entsprechende Flagge gesetzt werden, um diese Betriebsbereitschaft anzuzeigen. Die Steuereinrichtung 116 kann also im Bedarfsfall erneut ein Umschalten ansteuern.

Zu den Verdampfern 114a und 114b sind weder Heizeinrichtungen noch Pumpeinrichtungen gezeigt, diese sind aber wie grundsätzlich auch im Stand der Technik bekannt vorhanden und könnten analog so ausgeführt sein, wie zum Verdampfer 112b geschildert. Auch die Bypasspumpe 160 könnte herangezogen werden für das Einstellen der Unterdruckbedingungen. Das Zusammenspiel der Verdampfer 114a und 114b kann analog sein, wie zum Verdampferpaar 112 beschrieben. Da im gezeigten Beispiel der Verdampfer 114b aber als reiner Reserveverdampfer konzipiert ist, kann die Steuereinrichtung 116 z.B. anders als vorstehend beschrieben von dem Verdampfer 114b auf den Verdampfer 114a umschalten, sobald der Verdampfer 114a z.B. nach einem Nachfüllvorgang wieder Betriebsbereitschaft erreicht hat. Anders als zum Verdampferpaar 112 beschrieben würde die Steuereinrichtung 116 also nicht warten, bis im Reserveverdampfer 114b ein niedriger Füllstand erreicht und ein Nachfüllen erforderlich ist. Maßgeblich für das Umschalten wäre in dem Fall allein die Betriebsbereitschaft des Verdampfers 114a.

## Patentansprüche

1. Verfahren zur Versorgung einer Anlage (10) zur Beschichtung von Werkstücken (5) mit für den Beschichtungsprozess benötigten Prozessgasen,
wobei wenigstens zwei Grundgase in wenigstens zwei Grundgasleitungen (102, 104; 124, 125) geführt werden bis zu einem Mischpunkt (171, 172, 173) und dort zu einem Gasgemisch zusammengeführt werden,
wobei wenigstens eines der Grundgase erzeugt wird durch Überführen eines flüssigen Ausgangsfluides in den gasförmigen Zustand, nämlich durch Erhitzen auf eine Temperatur oberhalb von dessen Siedetemperatur,
wobei das Ausgangsfluid hierzu in einem Verdampfer (112a, 112b, 114a, 114b) bereitgestellt wird, in dem dann das Erhitzen auf eine Temperatur oberhalb der Siedetemperatur erfolgt und in dem über eine zugeordnete Pumpeinrichtung (250) Unterdruckbedingungen eingestellt werden, wobei der Verdampfer (112a, 112b, 114a, 114b) betrieben wird, einen Betriebsdruck und eine Betriebstemperatur zu erreichen und beizubehalten und bei Erreichen dieser Betriebswerte aus dem Verdampfer (112a, 112b, 114a, 114b) das entstehende Grundgas in die zugehörige Grundgasleitung (124, 125) abgegeben wird,
wobei der Verdampfer (112a, 112b, 114a, 114b) über eine Nachfüllleitung (210, 240) an einen Vorrat (212, 232) für das Ausgangsfluid angeschlossen ist und darüber zeitweise mit dem Ausgangsfluid nachbefüllt wird,
**dadurch gekennzeichnet, dass**
zusätzlich zu dem im Oberbegriff genannten ersten Verdampfer (112a, 114a) ein zweiter Verdampfer (112b, 114b) vorgesehen wird, und wobei das gleiche Ausgangsfluid auch im zweiten Verdampfer (112b, 114b) bereitgestellt wird, in dem ebenfalls ein Erhitzen auf eine Temperatur oberhalb der Siedetemperatur erfolgt und in dem ebenfalls über eine zugeordnete Pumpeinrichtung (250) Unterdruckbedingungen eingestellt werden, wobei der zweite Verdampfer (112b, 114b) auf dem gleichen Betriebsdruck und die gleiche Betriebstemperatur wie der erste Verdampfer (112a, 114a) betrieben wird, wobei der zweite Verdampfer (112b, 114b) das Grundgas in die zugehörige Grundgasleitung (124, 125) abgibt, wenn der erste Verdampfer (112a, 112b) kein Grundgas in die zugehörige Grundgasleitung (124, 125) abgibt und umgekehrt, sodass also zur Abgabe des Grundgases zwischen diesen beiden Verdampfern (112a, 112b; 114a, 114b) umgeschaltet werden kann, die ein Verdampferpaar (112, 114) bilden, wobei bevorzugt auch der zweite Verdampfer (112b, 114b) des Verdampferpaares (112, 114) über eine Nachfüllleitung (210, 240) an dem Vorrat (212, 232) für das Ausgangsfluid angeschlossen ist und darüber zeitweise mit dem Ausgangsfluid nachbefüllt wird, wobei bevorzugt das Nachfüllen des ersten Verdampfers (112a, 114a) erfolgt, wenn der zweite Verdampfer (112b, 114b) das Grundgas in die Grundgasleitung (124, 125) abgibt und umgekehrt.

2. Verfahren nach Anspruch 1, **dadurch gekennzeichnet, dass** die beiden Verdampfer (112a, 112b; 114a, 114b) des Verdampferpaares (112, 114) identische Mengen an dem Ausgangsfluid aufnehmen und insbesondere identisch ausgeführt sind.

3. Verfahren nach Anspruch 1 oder 2, wobei ein zweites Grundgas erzeugt wird durch Überführen eines zweiten flüssigen Ausgangsfluides in den gasförmigen Zustand, nämlich durch Erhitzen auf eine Temperatur oberhalb von dessen Siedetemperatur, wobei auch für das zweite Ausgangsfluid ein erster und ein zweiter Verdampfer (114a, 114b) bereitgestellt werden, in denen jeweils das Erhitzen auf eine Temperaturoberhalb der Siedetemperatur erfolgt und in denen über eine jeweils zugeordnete Pumpeinrichtung (250) jeweils Unterdruckbedingungen eingestellt werden, wobei die beiden Verdampfer (114a, 114b) für das zweite Ausgangsfluid ein zweites Verdampferpaar (114) bilden und jeweils betrieben werden, einen Betriebsdruck und eine Betriebstemperatur zu erreichen und beizubehalten und wobei bei Erreichen dieser Betriebswerte aus den Verdampfern (114a, 114b) das entstehende zweite Grundgas in eine zugehörige zweite Grundgasleitung (125) abgegeben werden kann,
**dadurch gekennzeichnet, dass**
der zweite Verdampfer (114b) das zweite Grundgas in die zugehörige zweite Grundgasleitung (125) abgibt, wenn der erste Verdampfer (114a) des zweiten Verdampferpaares (114) kein zweites Grundgas in die zugehörige zweite Grundgasleitung (125) abgibt, wobei bevorzugt sowohl der erste Verdampfer (114a) als auch der zweite Verdampfer (114b) des zweiten Verdampferpaares (114) jeweils über eine Nachfüllleitung (210) an eine Quelle (212) für das zweite Ausgangsfluid angeschlossen sind und jeweils zeitweise darüber nachbefüllt werden.

4. Verfahren nach einem der vorhergehenden Ansprüche, **dadurch gekennzeichnet, dass** jeder der Verdampfer (112a, 112b; 114a, 114b) nach einem Nachbefüllen erst dann mit der dazugehörigen Grundgasleitung (124, 125) verbunden werden kann, wenn wieder die Betriebswerte erreicht sind, wobei bevorzugt in einer Steuerung (116, 180, 200, 80) zu jedem Verdampfer (112a, 112b; 114a, 114b) die Information abgelegt ist, ob dieser die Betriebswerte erreicht hat, sodass diese Information das Erreichen oder Nichterreichen der Betriebswerte anzeigt, und vor dem Umschalten von einem ersten Verdampfer (112a; 114a) auf den zugehörigen zweiten Verdampfer (112b; 114b) eines Verdampferpaares (112; 114) oder umgekehrt zunächst die Abfrage der Information erfolgt, und ein Umschalten nur erfolgt, wenn diese Information das Erreichen der Betriebswerte anzeigt.

5. Verfahren nach einem der vorhergehenden Ansprüche, **dadurch gekennzeichnet, dass** in einem Fehlerfall eines Verdampfers (112a, 112b; 114a, 114b) eines Verdampferpaares (112; 114), der zum Zeitpunkt des Eintretens des Fehlerfalls ein bestimmtes Grundgas in die zugeordnete Grundgasleitung (124, 125) abgibt, automatisch der andere Verdampfer (112b, 112a; 114b, 114a) des Verdampferpaares (112; 114) das Abgeben dieses bestimmten Grundgases in die Grundgasleitung (124; 125) übernimmt.

6. Verfahren nach einem der vorhergehenden Ansprüche, **dadurch gekennzeichnet, dass** das Nachfüllen irgendeines der Verdampfer (112a, 112b; 114a, 114b) ausgeführt wird, wenn der Verdampfer einen Mindestfüllstand unterschreitet und/oder wenn auf den anderen Verdampfer (112b, 112a; 114b, 114a) des Verdampferpaares (112; 114) umgeschaltet wird.

7. Vorrichtung (100) zur Gaserzeugung und zur Versorgung einer Anlage (10) zur Beschichtung von Werkstücken (5) mit für den Beschichtungsprozess benötigten Prozessgasen,
wobei die Vorrichtung wenigstens zwei Grundgasleitungen (124, 125; 102, 104) zum getrennten Führen von wenigstens zwei Grundgasen in einer Strömungsrichtung und wenigstens ein Mischmittel (171, 172, 173) zum Zusammenführen und Mischen von wenigstens zwei der Grundgase zu einem Gasgemisch aufweist,
wobei die Vorrichtung zur Bereitstellung eines ersten Grundgases wenigstens einen Verdampfer (112a; 114a) aufweist, der zur Aufnahme einer Menge eines flüssigen Ausgangsfluides eingerichtet ist und der ausgebildet ist zur Überführung des flüssigen Ausgangsfluides in den gasförmigen Zustand, wobei der Verdampfer (112a; 114a) hierzu insbesondere Heizmittel (115) zum Erwärmen des Ausgangsfluides mindestens bis zu dessen Siedetemperatur aufweist und eine Pumpeinrichtung (250) zum Einstellen eines Unterdruckes im Verdampfer, wobei der Verdampfer steuerungstechnisch für das Erreichen und Beibehalten einer Betriebstemperatur und eines Betriebsdruckes eingerichtet ist,
wobei die Vorrichtung (100) zur Bereitstellung des gleichen Grundgases einen zweiten Verdampfer (112b; 114b) aufweist, der zur Aufnahme einer Menge des flüssigen Ausgangsfluides eingerichtet ist, und der mit dem ersten Verdampfer (112a; 114a) ein Verdampferpaar (112; 114) bildet,
**dadurch gekennzeichnet, dass**
der zweite Verdampfer (112b; 114b) ebenfalls ausgebildet ist, das in ihm aufgenommene flüssigen Ausgangsfluid in den gasförmigen Zustand zu überführen, wobei er hierzu insbesondere Heizmittel (115) zum Erwärmen des Ausgangsfluides mindestens bis zu dessen Siedetemperatur aufweist und eine Pumpeinrichtung (250) zum Einstellen eines Unterdruckes im Verdampfer (112b; 114b), wobei der zweite Verdampfer (112b; 114b) ebenfalls steuerungstechnisch eingerichtet ist für das Erreichen und Beibehalten der Betriebstemperatur und des Betriebsdruckes, wobei sowohl der erste Verdampfer (112a; 114a) als auch der zweite Verdampfer (112b; 114b) jeweils über eine Nachfüllleitung (210; 240) an einen Vorrat (212; 232) für das Ausgangsfluid angeschlossen sind, wobei die Vorrichtung (100) eine Steuerungseinrichtung (80, 116, 180, 200) aufweist, die ausgebildet und eingerichtet ist zur Ausführung des Verfahrens nach einem der Ansprüche 1 oder 2 oder 4 bis 6, wobei die Vorrichtung (100) bevorzugt zur Bereitstellung eines zweiten Grundgases ein zweites Verdampferpaar (114) aufweist mit den Merkmalen, wie zuvor für das erste Verdampferpaar (112) genannt, wobei die Steuerungseinrichtung (80, 116, 180, 200) ausgebildet und eingerichtet ist zur Ausführung des Verfahrens nach einem der Ansprüche 3 bis 6.

8. Vorrichtung (100) nach Anspruch 7, **dadurch gekennzeichnet, dass** der erste und der zweite Verdampfer (112a, 112b; 114a, 114b) jedes Verdampferpaares (112; 114) identisch ausgeführt sind.

9. Anlage (10) zur Beschichtung von Werkstücken (5), insbesondere zur Beschichtung von Innenwänden von Behältern (5), insbesondere mittels eines PECVD-Verfahrens, insbesondere mittels eines mikrowelleninduzierten PECVD-Verfahrens, mit einer Vorrichtung (100) zur Gaserzeugung und zur Bereitstellung der für den Beschichtungsprozess benötigten Prozessgasen, wobei diese Vorrichtung (100) nach einem der vorhergehenden Ansprüche 7 oder 8 ausgebildet ist.
